# EUROPÄISCHE PATENTSCHRIFT

(11) **EP 3 725 525 B1**
(45) Veröffentlichungstag und Bekanntmachung des Hinweises auf die Patenterteilung: **28.02.2024**
(21) Anmeldenummer: 19170346.1
(22) Anmeldetag: 18.04.2019
(51) Int. Cl.: B41F 15/08, B41F 15/16, B41F 15/18, H05K 3/12, B41F 23/00, B41F 23/04

(54) **VORRICHTUNG UND VERFAHREN ZUR HERSTELLUNG VON DREIDIMENSIONALEN SIEBDRUCKWERKSTÜCKEN**
DEVICE AND METHOD FOR THE PREPARATION OF THREE-DIMENSIONAL SCREEN PRINTING WORKPIECES
PROCÉDÉ ET DISPOSITIF DE FABRICATION DE PIÈCES À USINER TRIDIMENSIONELLES IMPRIMÉES PAR SÉRIGRAPHIE

(43) Veröffentlichungstag der Anmeldung: 21.10.2020
(73) Patentinhaber: Exentis Knowledge GmbH, 5608 Stetten AG (CH)
(72) Erfinder: VASIC, Srdan, 5608 Stetten (CH); BRAMMER, Ralf, 5608 Stetten (CH)
(74) Vertreter: Wenzel Nemetzade Warthmüller Patentanwälte Part mbB

(56) Entgegenhaltungen:
- EP-A1- 2 711 183
- EP-A1- 3 116 287
- EP-A1- 3 305 525
- DE-A1-102008 033 382
- US-A- 4 930 413
- US-A1- 2004 170 459
- Laxxon Medical: "3D Siebdruck Animation", Youtube, 17. April 2019 (2019-04-17), Seite 1 pp., XP054979839, Gefunden im Internet: URL:https://www.youtube.com/watch?v=cvt02W l7hJY [gefunden am 2019-10-22]
- Fraunhofer IFAM Dresden: "Additive Fertigung mit 3D-Siebdruck", Youtube, 4. März 2019 (2019-03-04), Seite 1 pp., XP054979817, Gefunden im Internet: URL:https://www.youtube.com/watch?v=d7sx4U K6if8 [gefunden am 2019-10-18]
- Exentis Group AG: "3D Mass Customization", Youtube, 24. November 2017 (2017-11-24), Seite 1 pp., XP054979818, Gefunden im Internet: URL:https://www.youtube.com/watch?v=hlmJkb sPtRY [gefunden am 2019-10-18]

## Beschreibung

Die vorliegende Erfindung betrifft eine 3D-Siebdruckanlage zur Herstellung von dreidimensionalen Siebdruckwerkstücken. Ebenso betrifft die vorliegende Erfindung ein Verfahren zur Herstellung von dreidimensionalen Siebdruckwerkstücken.

Aus dem Video der Laxxon Medical mit dem Titel "3D Siebdruck Animation" (URL: https://www.youtube.com/watch?v=cvt02WI7hJY, vom 17. April 2019) ist eine 3D-Siebdruckanlage zur Herstellung von dreidimensionalen Siebdruckwerkstücken bekannt. Aus dem Video geht hervor, dass die 3D-Siebdruckanlage mit einer Druckeinrichtung für die schichtweise Erzeugung von Siebdruckwerkstücken in mehreren Druckvorgängen ausgestattet ist. Ferner weist die in diesem Video gezeigte 3D-Siebdruckanlage eine Trocknungseinrichtung auf, in der die Siebdruckwerkstücke zur Trocknung zweitweise verweilen.

Ferner ist aus dem Stand der Technik in der Druckschrift WO 2014/187567 A2 eine Anlage zur Herstellung von dreidimensionalen Siebdruckwerkstücken bekannt. Bei dieser Anlagenkonzeption ist eine Druckstation vorgesehen, in die ein Drucktisch ein- und ausfahrbar angeordnet ist. Dabei kann ein Drucktisch zum Drucken einer Lage in die Druckeinrichtung hineinbewegt und zum Trocknen aus der Druckeinrichtung heraus und in eine angrenzend an die Druckstation positionierte Härteanlage bewegt werden. Es besteht gemäß der WO 2014/187567 A2 schließlich die Möglichkeit, zwei angrenzend an die Druckstation angeordnete Härteanlagen vorzusehen. In diesem Fall sind auch zwei Drucktische vorgesehen, die abwechselnd zueinander in die Druckstation hineinbewegt und zum Trocknen in die jeweils zugeordnete Härteanlage verfahren werden.

Trotz der Anordnung einer Mehrzahl von Trocknungsstationen kann es im Betrieb jedoch zu einer unzureichenden Auslastung der Druckstation kommen. Dies ist dem Umstand geschuldet, dass die Trocknung einer gedruckten Schicht innerhalb einer Trocknungsstation mehr Zeit in Anspruch nimmt als das Drucken einer Lage. Die Produktivität der Anlage ist somit begrenzt.

Vor dem oben dargelegten Hintergrund bestand die Aufgabe der vorliegenden Erfindung darin, eine 3D-Siebdruckanlage zur Herstellung von dreidimensionalen Siebdruckwerkstücken anzugeben, die eine erhöhte Produktivität bei gleichzeitig hoher Betriebssicherheit gewährleistet. Ebenso bestand die Aufgabe darin, ein Verfahren zur Herstellung von dreidimensionalen Siebdruckwerkstücken anzugeben.

In Bezug auf die 3D-Siebdruckanlage ist diese Aufgabe durch den Gegenstand des Anspruchs 1 gelöst worden. Ein erfindungsgemäßes Verfahren ist Gegenstand von Anspruch 15. Vorteilhafte Ausgestaltungen sind Gegenstand der abhängigen Ansprüche und werden nachfolgend erläutert.

Erfindungsgemäß ist eine 3D-Siebdruckanlage zur Herstellung von dreidimensionalen Siebdruckwerkstücken, bevorzugt eine automatisierte 3D-Siebdruckanlage, vorgesehen.

Die erfindungsgemäße 3D-Siebdruckanlage weist wenigstens eine Druckeinrichtung für die schichtweise Erzeugung zumindest eines Siebdruckwerkstücks in mehreren Druckvorgängen und wenigstens eine Trocknungseinrichtung für ein Siebdruckwerkstück auf. Erfindungsgemäß ist nun vorgesehen, dass die Trocknungseinrichtung als Trocknungsstrecke für den kontinuierlichen Trocknungsdurchlauf von Siebdruckwerkstücken ausgebildet ist.

Es können demnach zahlreiche Siebdruckwerkstücke beziehungsweise teilweise fertig gedruckte Siebdruckerzeugnisse kontinuierlich durch die Trocknungseinrichtung geleitet werden. Es versteht sich, dass eine solche Trocknungsstrecke auch für den kontinuierlichen Trocknungsdurchlauf von Werkstückträgern ausgebildet sein kann. Dies gestattet einen insgesamt kontinuierlichen Produktionsprozess für eine Mehrzahl von Siebdruckwerkstücken beziehungsweise mit einer Mehrzahl von Werkstückträgern, auf denen Siebdruckwerkstücke angeordnet sein können. Sowohl das Bedrucken als auch das Trocknen kann durch einen kontinuierlichen Trocknungsdurchlauf im Wesentlichen unterbrechungsfrei vorgenommen werden, wodurch die Gesamtproduktivität der 3D-Siebdruckanlage gesteigert werden kann.

In der nachfolgenden Beschreibung wird die 3D-Siebdruckanlage auch als Vorrichtung bezeichnet.

Unter dreidimensionalem Siebdruck kann vorliegend in besonders bevorzugter Weise ein additives Fertigungsverfahren verstanden werden, bei dem eine pulverbasierte Suspension mithilfe einer Rakel durch eine feste Druckmaske auf ein Substrat übertragen und getrocknet wird. Diese Vorgehensweise kann mehrmals wiederholt werden, bis die jeweils gewünschte Bauteilhöhe oder Bauteilform erreicht ist. In einem abschließenden Prozessschritt kann das so erzeugte Bauteil gesintert werden. Hierdurch kann ein Siebdruckwerkstück entstehen.

Unter Siebdruckwerkstück können vorliegend in bevorzugter Weise Werkstücke verstanden werden, die einem Sinterschritt zu unterziehen sind beziehungsweise unterzogen worden sind. Dies betrifft insbesondere Werkstücke aus einem Metall, einer Keramik, einem Glasmaterial und/oder einem Kunststoffmaterial. Insbesondere kommen hierzu Legierungen aus Stahl, Nickel, Kupfer, Titan und/oder Keramiklegierungen in Betracht.

Druckerzeugnisse aus Kunststoffmaterialien können durch die Bezeichnung "dreidimensionales Siebdruckwerkstück" ausgeschlossen oder mitumfasst sein. Insbesondere besteht auch die Möglichkeit, gedruckte Werkstücklagen aus Kunststoffmaterial einem Sinterschritt zu unterziehen.

Gemäß einer bevorzugten Ausgestaltung weist die Vorrichtung wenigstens einen Werkstückträger für zumindest ein Siebdruckwerkstück auf. Ferner kann die Druckeinrichtung mit wenigstens einer von dem Werkstückträger gesondert ausgebildeten Drucktischplatte ausgestattet sein, auf die der Werkstückträger zur Durchführung eines Druckvorgangs positionierbar ist. Schließlich kann der Werkstückträger zwischen zwei aufeinanderfolgenden Druckvorgängen für ein Siebdruckwerkstück zur Trocknung des Siebdruckwerkstücks von der Drucktischplatte lösbar sein.

Ein Siebdruckwerkstück kann demnach schichtweise erzeugt und zwischen den Druckvorgängen für ein Siebdruckwerkstück kann der jeweilige Werkstückträger von der Drucktischplatte gelöst werden. Hierdurch können die einzelnen Schichten eines Siebdruckwerkstücks zwischen zwei aufeinanderfolgenden Druckvorgängen in einer von der Drucktischplatte gelösten Stellung getrocknet beziehungsweise durch die Trocknungseinrichtung für den kontinuierlichen Trocknungsdurchlauf geleitet werden.

Während des Betriebs kann somit die Drucktischplatte in vorteilhafter Weise mit unterschiedlichen Werkstückträgern beschickt werden, sodass die Auslastung der Druckeinrichtung erhöht werden kann. Insbesondere können die Stillstandzeiten der Druckeinrichtung auf die für die Umrüstung beziehungsweise Beschickung mit einem neuen Werkstückträger erforderlichen Zeiten reduziert werden. Die Gesamtproduktivität der Anlage kann auf diese Weise weiter verbessert werden. Hieraus ergibt sich eine besondere Tauglichkeit der Vorrichtung für den Einsatz in der Massenfertigung.

In bevorzugter Weise kann die Vorrichtung dazu ausgebildet sein, dass das Druckgut beziehungsweise das zu druckende Werkstück oder Bauteil zwischen dem Druck unterschiedlicher Lagen auf dem Werkstückträger verbleibt. Hierdurch kann die Gefahr von Beschädigungen des Druckguts, insbesondere eines noch nicht vollständig gedruckten Werkstücks oder Bauteils, verringert werden.

In weiter bevorzugter Weise kann die Vorrichtung zur Erzeugung von Werkstück- oder Bauteilgenauigkeiten von bis zu 50 µm, besonders bevorzugt von bis zu 30 µm, insbesondere von bis zu 20 µm, weiter bevorzugt von bis zu 10 µm, ausgebildet sein. Unter Werkstück- beziehungsweise Bauteilgenauigkeit können vorliegend Genauigkeiten einer Außen- und/oder gegebenenfalls vorhandenen Innengeometrie eines Werkstücks beziehungsweise Bauteils verstanden werden. Es kann sich hierbei insbesondere um Genauigkeiten eines fertig erstellten Werkstücks beziehungsweise Bauteils handeln. Solche Genauigkeiten können sich auf Abmessungen quer zu einer Druckaufbaurichtung beziehen, also entlang einer X-Achse und/oder einer Y-Achse. Ebenso können sich solche Genauigkeiten auf Abmessungen in einer Druckaufbaurichtung beziehen, also entlang einer Z-Achse. Die voranstehenden Achsbezeichnungen können insbesondere mit den Achsbezeichnungen einer vorliegend beanspruchten Vorrichtung korrespondieren, auf die nachfolgend noch näher eingegangen wird.

Gemäß einer weiter bevorzugten Ausgestaltung kann die Vorrichtung zur Erzeugung von Druckhöhen, insbesondere Werkstück- oder Bauteilhöhen, von bis zu 200 mm, von bis zu 100 mm, insbesondere von bis zu 75 mm, bevorzugt von bis zu 50 mm, weiter bevorzugt von bis zu 30 mm, noch weiter bevorzugt von bis zu 20 mm, noch weiter bevorzugt von bis zu 10 mm, ausgebildet sein. Ferner kann die Vorrichtung zur Erzeugung von Druckhöhen, insbesondere Werkstück- oder Bauteilhöhen, von weniger als zu 200 µm, insbesondere von weniger als 100 µm, insbesondere von weniger als 50 µm, besonders bevorzugt von weniger als 25 µm, ausgebildet sein.

In weiter bevorzugter Weise kann die Vorrichtung zur Erzeugung von Druckschichten mit einer Dicke von weniger als 1 mm, insbesondere von weniger als 0,5 mm, bevorzugt von weniger als 0,25 mm, weiter bevorzugt von weniger als 0,2 mm, noch weiter bevorzugt von weniger als 0,1 mm, besonders bevorzugt von weniger als 0,05 mm oder von weniger als 0,025 mm, ausgebildet sein.

In noch weiter bevorzugter Weise kann die Vorrichtung zur Erzeugung von Bauteilen beziehungsweise Werkstücken mit einer Anzahl von bis zu 1000 Schichten, insbesondere von bis zu 750 Schichten, bevorzugt von bis zu 500 Schichten oder von bis zu 250 Schichten, ausgebildet sein. Dabei kann ein Siebdruckwerkstück mindestens zwei Druckschichten, insbesondere mehr als zwei Druckschichten, aufweisen.

Gemäß einer bevorzugten Ausführungsform kann eine Transporteinrichtung für den automatisierten Transport wenigstens eines Werkstückträgers, insbesondere für eine Mehrzahl von Werkstückträgern, vorgesehen sein. Dabei kann die Transporteinrichtung bevorzugt einen Transportkreislauf für den automatisierten Transport des wenigstens einen Werkstückträgers aufweisen und/oder als Transportkreislauf ausgebildet sein. Ebenso kann die Transporteinrichtung für den automatisierten Transport im Kreislauf zwischen der Druckeinrichtung und wenigstens einer von der Druckeinrichtung und/oder der Drucktischplatte beabstandeten Position eingerichtet sein. Durch einen derartigen Transportkreislauf kann ein besonders günstiger Materialfluss innerhalb der Vorrichtung bewerkstelligt werden, sodass die Gesamtproduktivität der Vorrichtung verbessert werden kann. Eine manuelle Handhabung einzelner Werkstückträger kann hierdurch vollständig vermieden oder auf ein geringes Maß reduziert werden.

Gemäß einer weiter bevorzugten Ausgestaltung kann die Transporteinrichtung und/oder der Transportkreislauf zumindest abschnittsweise mehrspurig und/oder zumindest abschnittsweise einspurig ausgebildet sein. Es lassen sich auf diese Weise unterschiedliche Transportkapazitäten für unterschiedliche Transportabschnitte realisieren.

Nach einer weiter bevorzugten Ausgestaltung kann die Transporteinrichtung zumindest abschnittsweise durch ein Fördermittel, insbesondere einen Bandförderer, gebildet sein. Es kann weiterhin von Vorteil sein, wenn die Transporteinrichtung und/oder der Transportkreislauf durch ein glasfaserteflonbeschichtetes Gewebeband oder mehrere solcher Gewebebänder ausgebildet ist. Eine derart ausgebildete Transporteinrichtung beziehungsweise ein solcher Transportkreislauf gewährleistet ein hohes Maß an Betriebssicherheit.

Gemäß einer weiter bevorzugten Ausführungsform kann die Transporteinrichtung eine Mehrzahl unter einem Winkel zueinander verlaufende Transportstrecken aufweisen. Ferner kann die Transporteinrichtung wenigstens einen Eckumsetzer aufweisen, insbesondere mit quer zueinander verlaufenden Förderbändern. Der Verlauf der Transporteinrichtung kann auf diese Weise flexibel an die jeweiligen Anforderungen der Vorrichtung angepasst beziehungsweise in geeigneter Weise zur Installation ausgewählt werden.

Gemäß einer Ausführungsform der vorliegenden Erfindung kann eine Positionier- und/oder Handhabungseinrichtung zur Vorpositionierung eines Werkstückträgers auf der Drucktischplatte vorgesehen sein, insbesondere zur Vorpositionierung mit einer Genauigkeitstoleranz von +/- 500 µm betreffend die Position und/oder von bis zu +/- 5° betreffend die Ausrichtung beziehungsweise Rotationslage des Werkstückträgers.

Auf diese Weise besteht die Möglichkeit, den Werkstückträger verhältnismäßig präzise auf der Drucktischplatte zu repositionieren beziehungsweise für weitergehende Schritte vorbereitend zu repositionieren.

Ferner kann eine Positionier- und/oder Handhabungseinrichtung zur Vorpositionierung eines Werkstückträgers auf der Drucktischplatte mit einer Genauigkeitstoleranz von +/- 1000 µm betreffend die Position und/oder von bis zu +/- 10° betreffend die Ausrichtung beziehungsweise Rotationslage des Werkstückträgers ausgebildet sein.

Ebenso kann eine Positionier- und/oder Handhabungseinrichtung zur Vorpositionierung eines Werkstückträgers auf der Drucktischplatte mit einer Genauigkeitstoleranz von +/- 200 µm betreffend die Position und/oder von bis zu +/- 2° betreffend die Ausrichtung beziehungsweise Rotationslage des Werkstückträgers ausgebildet sein.

Ebenso kann eine Positionier- und/oder Handhabungseinrichtung zur Vorpositionierung eines Werkstückträgers auf der Drucktischplatte mit einer Genauigkeitstoleranz von +/- 100 µm betreffend die Position und/oder von bis zu +/- 1° betreffend die Ausrichtung beziehungsweise Rotationslage des Werkstückträgers ausgebildet sein.

Ebenso kann eine Positionier- und/oder Handhabungseinrichtung zur Vorpositionierung eines Werkstückträgers auf der Drucktischplatte mit einer Genauigkeitstoleranz von +/- 50 µm betreffend die Position und/oder von bis zu +/- 0,5° betreffend die Ausrichtung beziehungsweise Rotationslage des Werkstückträgers ausgebildet sein.

Ebenso kann eine Positionier- und/oder Handhabungseinrichtung zur Vorpositionierung eines Werkstückträgers auf der Drucktischplatte mit einer Genauigkeitstoleranz von +/- 25 µm betreffend die Position und/oder von bis zu +/- 0,25° betreffend die Ausrichtung beziehungsweise Rotationslage des Werkstückträgers ausgebildet sein.

Die voranstehenden Genauigkeitsbereiche beziehen sich insbesondere auf Positionen entlang einer Ebene quer zur Aufbaurichtung des Siebdruckwerkstücks (X-Richtung und Y-Richtung) beziehungsweise auf die Rotationslage um eine in Aufbaurichtung verlaufende Achse (Z-Achse).

Gemäß einer Ausführungsform der vorliegenden Erfindung kann die Vorrichtung mit einer Positionier- und/oder Handhabungseinrichtung ausgestattet sein, durch die der Werkstückträger automatisiert und/oder definiert auf der Drucktischplatte positionierbar ist. Durch eine solche Positionier- und/oder Handhabungseinrichtung kann die Positionsgenauigkeit des Werkstückträgers auf der Drucktischplatte sichergestellt und die Notwendigkeit einer manuellen Handhabung vermieden werden. Insbesondere besteht die Möglichkeit, durch die Positionier- und/oder Handhabungseinrichtung den Werkstückträger präzise oder verhältnismäßig präzise zu repositionieren.

Bei einer solchen automatisierten und/oder definierten Positionierung durch eine einer Positionier- und/oder Handhabungseinrichtung kann es sich um eine Vorpositionierung handeln, insbesondere mit den voranstehenden Genauigkeitsangaben. Es kann nach einer solchen Vorpositionierung auch eine Feinpositionierung erfolgen, auf die nachfolgend noch eingegangen wird. Ebenso kann bereits durch eine Positionier- und/oder Handhabungseinrichtung eine Feinpositionierung erfolgen.

Die Möglichkeit der präzisen Repositionierung des Werkstückträgers kann für den Druck nachfolgender Schichten besonders von Vorteil sein. Durch eine Positionier- und/oder Handhabungseinrichtung kann der Werkstückträger zunächst auf einer bestimmten Position oder in einer bestimmten Ausrichtung auf der Drucktischplatte angeordnet werden. Nachdem in dieser Position oder Ausrichtung des Werkstückträgers ein Druckvorgang erfolgt ist, kann der Werkstückträger zur Trocknung von der Drucktischplatte gelöst werden. Durch die Positionier- und/oder Handhabungseinrichtung kann nun eine präzise Repositionierung des Werkstückträgers auf der Drucktischplatte vorgenommen werden, gegebenenfalls mit Feinpositionierung im Anschluss an eine Vorpositionierung.

Mit anderen Worten kann der Werkstückträger entsprechend des vorangegangenen Drucks auf der Drucktischplatte positioniert werden. Abweichungen in der Position und/oder Ausrichtung des Werkstückträgers auf der Drucktischplatte zwischen zwei aufeinanderfolgenden Druckvorgängen können so vermieden werden.

Weiter bevorzugt kann die Positionier- und/oder Handhabungsreinrichtung zur Lageerkennung des Werkstückträgers ausgebildet sein. Die Repositionierung eines Werkstückträgers auf dem Drucktisch kann auf diese Weise mit besonders hoher Genauigkeit erfolgen. Insbesondere kann die Lageerkennung des Werkstückträgers Einfluss auf den Prozess der Repositionierung nehmen und damit eine korrekte Positionierung und/oder Ausrichtung des Werkstückträgers auf der Drucktischplatte begünstigen.

Eine Lageerkennung des Werkstückträgers durch die Positionier- und/oder Handhabungseinrichtung kann dabei sowohl in einer Ausgangsposition und/oder in einer Endposition erfolgen. Ausgangs- und Endposition können beispielsweise auf der Drucktischplatte oder auch in einem Zuführbereich der Drucktischplatte beziehungsweise in einem Abführbereich der Drucktischplatte vorgesehen sein.

Weiter bevorzugt kann die Positionier- und/oder Handhabungsreinrichtung als Teil der Transporteinrichtung ausgebildet sein. Es kann somit ein hohes Maß an Integration der unterschiedlichen Vorrichtungsbestandteile und damit auch ein hoher Automatisierungsgrad realisiert werden, sodass sich eine besonders vorteilhafte Eignung für die Massenfertigung von 3D-Siebdruckwerkstücken ergibt.

Gemäß einer weiteren Ausführungsform kann die Positioniereinrichtung ein Fördermittel, insbesondere einen Bandförderer, aufweisen. Dabei kann das Fördermittel und/oder der Bandförderer bevorzugt bis in die Drucktischplatte hinein verlaufen und/oder in der Drucktischplatte eingelassen und/oder relativ zur Drucktischplatte absenkbar und/oder anhebbar sein. Ein solches Fördermittel kann mit nur geringem Aufwand und verhältnismäßig hoher Prozesssicherheit Werkstückträger bis auf die Drucktischplatte befördern. Durch ein Absenken des Fördermittels beziehungsweise des Bandförderers kann der Werkstückträger auf der Drucktischplatte abgestellt werden. Durch Anheben des Fördermittels beziehungsweise des Bandförderers kann der Werkstückträger wieder von der Drucktischplatte angehoben und von dieser wegtransportiert werden.

Ferner kann es sich bei der Handhabungseinrichtung auch um eine Pick-and-Place-Einrichtung handeln. Die Handhabungseinrichtung kann auch als Handhabungsroboter ausgebildet sein. Derartige Handhabungseinrichtungen gewährleisten eine hohe Genauigkeit und Flexibilität im Betrieb.

Insgesamt kann die automatisierte Handhabung eines Werkstückträgers durch die Positionier- und/oder Handhabungseinrichtung eine weiter verbesserte Produktivität der Vorrichtung gewährleisten. Manuelle Bedienarbeiten der Vorrichtung können durch das Vorsehen einer Positionier- und/oder Handhabungseinrichtung auf ein geringes Maß reduziert oder vollständig vermieden werden. Die Gefahr von Beeinträchtigungen des Produktionsprozesses aufgrund von Bedienfehlern wird auf diese Weise verringert.

Gemäß einer weiteren Ausführungsform kann die Positionier- und/oder Handhabungseinrichtung zur mehrseitigen Beschickung der Drucktischplatte mit Werkstückträgern ausgebildet sein. Dabei besteht die Möglichkeit, dass an mehreren Seiten der Drucktischplatte jeweils eine Positionier- und/oder Handhabungseinrichtung angeordnet ist, insbesondere zur Beschickung der Drucktischplatte von unterschiedlichen Seiten. Hierdurch kann die Auslastung der Druckeinrichtung weiter erhöht werden, wodurch die Produktivität verbessert werden kann.

Gemäß einer Ausgestaltung der erfindungsgemäßen Vorrichtung ist eine Ausrichteinrichtung vorgesehen, durch die der Werkstückträger auf der Druckplatte ausgerichtet und/oder definiert positionierbar ist. Bei zwei aufeinanderfolgenden Druckvorgängen kann auf diese Weise die jeweils korrekte Lage des Werkstückträgers auf der Drucktischplatte sichergestellt werden. Die Erzeugung einer jeweils gewünschten Bauteilgeometrie kann somit sicher bewerkstelligt werden. Insbesondere kann auf diese Weise sichergestellt werden, dass ein Werkstückträger bis zum Abschluss des gesamten Druckprozesses, einschließlich des Druckens mehrerer Drucklagen, mit einer ausreichenden Wiederholgenauigkeit auf der Drucktischplatte positioniert wird. Die Prozesssicherheit wird hierdurch verbessert.

Eine Ausrichteinrichtung kann beispielsweise durch ein mechanisches Positionierelement und/oder durch zumindest einen Anschlag gebildet sein. Auf diese Weise lässt sich die Lagegenauigkeit des Werkstückträgers auf der Drucktischplatte mit besonders geringem Aufwand sicherstellen. Ebenso besteht die Möglichkeit, dass die Ausrichteinrichtung durch eine voranstehend beschriebene Positionier- und/oder Handhabungseinrichtung gebildet ist. Eine Ausrichteinrichtung kann in vorteilhafter Weise eine Vorpositionierung mit den voranstehend genannten Genauigkeitsangaben zur Vorpositionierung gewährleisten.

Die Ausrichteinrichtung kann ferner als Teil der Transporteinrichtung und/oder der Druckeinrichtung ausgebildet sein, wodurch die Integration der Vorrichtung, insbesondere der unterschiedlichen Einrichtungen, weiter erhöht werden kann. Bevorzugt lässt sich der Automatisierungsgrad hierdurch erhöhen und damit die Produktivität verbessern.

In weiter bevorzugter Weise kann die Transporteinrichtung zumindest abschnittsweise entlang von wenigstens zwei Ebenen verlaufen, insbesondere zwei Höhenebenen und/oder zwei in Höhenrichtung übereinander verlaufende Ebenen. Die Flexibilität des Verlaufs der Transporteinrichtung kann hierdurch verbessert werden. Zwischen den zwei Ebenen der Transporteinrichtung kann eine Hubeinrichtung, insbesondere eine Liftanordnung, vorgesehen sein, bevorzugt eine Mehrzahl von Hubeinrichtungen. Die Transporteinrichtung kann ferner zumindest abschnittsweise mit einem Höhengefälle ausgebildet sein, insbesondere einem zwischen zwei Ebenen der Transporteinrichtung verlaufenden Höhengefälle. Ein solches Höhengefälle kann bevorzugt auf einer Rücklaufstrecke zur Druckeinrichtung ausgebildet sein. Hierdurch kann im Rücklauf gezielt eine tiefere Ebene angesteuert werden. Durch das Höhengefälle kann zumindest abschnittsweise der Einfluss der Schwerkraft zur Beförderung von Werkstückträgern genutzt werden.

Gemäß einer weiter bevorzugten Ausgestaltung kann die erfindungsgemäße Vorrichtung mit wenigstens einer Trocknungseinrichtung für ein Siebdruckwerkstück ausgestattet sein. Durch eine solche Trocknungseinrichtung kann nach dem Auftrag einer Drucklage eine zuverlässige Trocknung der zuletzt durchgeführten Drucklage vorgenommen werden, um dann wiederum die nächste Drucklage auf das Siebdruckwerkstück aufzubringen.

Die Trocknungsstrecke ist bevorzugt als Teil der Transporteinrichtung ausgebildet, sodass die Integration der Vorrichtung weiter verbessert werden kann. Insbesondere kann die Transporteinrichtung durch die Trocknungseinrichtung hindurch verlaufen, sodass manuelle Handhabungen der Werkstückträger vollständig vermieden werden können.

In weiter bevorzugter Weise ist der Werkstückträger unabhängig von der Drucktischplatte durch die Trocknungseinrichtung verfahrbar, insbesondere automatisiert durch die Trocknungseinrichtung verfahrbar. Es ist dementsprechend vorgesehen, dass durch das Lösen des Werkstückträgers von der Drucktischplatte nach erfolgtem Druck der Werkstückträger ohne Drucktischplatte in die Trocknungseinrichtung bewegt wird und somit auch nur der Werkstückträger etwaigen Temperaturbelastungen ausgesetzt wird. Die Drucktischplatte bleibt somit stets außerhalb der Trocknungseinrichtung und wird keinen Temperaturbelastungen ausgesetzt, wodurch die Drucktischplatte selbst beziehungsweise auch periphere Komponenten für die Drucktischplatte geringerem Verschleiß ausgesetzt beziehungsweise mit verhältnismäßig geringem konstruktivem Aufwand realisiert werden können.

Gemäß einer weiter bevorzugten Ausgestaltung ist der Werkstückträger automatisiert durch die Trocknungseinrichtung verfahrbar und/oder mit variabel einstellbarer Geschwindigkeit durch die Trocknungseinrichtung verfahrbar. Es lässt sich durch die automatisierte Verfahrbarkeit ein besonders geringer Handhabungsaufwand für den Werkstückträger sicherstellen. Durch die variabel einstellbare Geschwindigkeit für das Verfahren des Werkstückträgers durch die Trocknungseinrichtung kann mit nur geringem Aufwand die Trocknungsintensität für die jeweiligen Siebdruckwerkstücke angepasst werden. Ebenso lässt sich über die Einstellung der Verfahrgeschwindigkeit eine Anpassung an die Anzahl der im Umlauf befindlichen Werkstückträger beziehungsweise eine Anpassung an die Druckgeschwindigkeit in der Druckeinrichtung vornehmen, sodass insgesamt ein im Wesentlichen unterbrechungsfreier beziehungsweise quasikontinuierlicher Produktionsprozess innerhalb der Vorrichtung gewährleistet werden kann.

Es kann weiter von Vorteil sein, wenn die Trocknungseinrichtung zur Trocknung für zumindest ein Siebdruckwerkstück mittels Konvektion und/oder Wärmestrahlung, insbesondere Infrarotwärmestrahlung, eingerichtet ist. Durch Nutzung unterschiedlicher Wärmeübertragungsmechanismen kann der Trocknungsprozess flexibel an die jeweiligen Einsatzbedingungen angepasst werden.

In bevorzugter Weise weist die Trocknungseinrichtung eine Mehrzahl von Konvektions- und/oder Wärmestrahlungseinheiten auf. Ferner kann in vorteilhafter Weise die aktive Länge der Trocknungseinrichtung variabel einstellbar sein, bevorzugt durch Aktivieren und/oder Deaktivieren zumindest einer Konvektions- und/oder Wärmestrahlungseinheit. Dementsprechend kann der Wärmeeintrag in ein Siebdruckwerkstück durch Anpassung der aktiven Länge der Trocknungseinrichtung je nach Einsatzbedingungen angepasst werden. Das Aktivieren beziehungsweise Deaktivieren von Konvektions- und/oder Wärmestrahlungseinheiten kann dabei mit nur geringem Aufwand bewerkstelligt werden. Die Gesamtflexibilität der Vorrichtung wird auf diese Weise verbessert.

Bei der Trocknungseinrichtung kann es sich insbesondere um einen Trocknungstunnel handeln, durch den die Werkstückträger zur Trocknung automatisiert hindurchbefördert werden. Innerhalb des Trocknungstunnels können Konvektions- und/oder Wärmestrahlungseinheiten vorgesehen sein. Die aktive Länge des Trocknungstunnels kann variabel einstellbar sein.

Gemäß einer weiter bevorzugten Ausgestaltung kann die Anzahl von Trocknungseinrichtungen gleich oder geringer sein als die Anzahl an Druckeinrichtungen. Beispielsweise können mehrere Druckeinrichtungen einer einzigen Trocknungseinrichtung zugeordnet sein, sodass Werkstückträger von mehreren Druckeinrichtungen zu einer einzigen Trocknungseinrichtung geführt werden. Es kann auf diese Weise eine verhältnismäßig hohe Druckkapazität realisiert werden und innerhalb der Trocknungseinrichtung, beispielsweise durch eine verhältnismäßig hohe Trocknungsintensität, ein großes Trocknungsvolumen bereitgestellt werden.

Ebenso ist es möglich, dass die Anzahl an Trocknungseinrichtungen größer ist als die Anzahl an Druckeinrichtungen. Auf diese Weise kann eine besonders hohe Auslastung von Druckeinrichtungen sichergestellt werden. Die Gefahr von Stillstandzeiten oder Totzeiten für einzelne Druckeinrichtungen kann auf diese Weise verringert werden.

Es besteht ferner die Möglichkeit, dass mehrere Druckeinrichtungen vorgesehen sind, wobei jeder Druckeinrichtung zumindest eine Trocknungseinrichtung und/oder jede Trocknungseinrichtung zumindest einer Druckeinrichtung zugeordnet ist. Die Bewegungsabläufe einzelner Werkstückträger können auf diese Weise geeignet festgelegt und auf den jeweiligen Anwendungsfall angepasst werden.

Gemäß einer weiter bevorzugten Ausgestaltung kann eine Mehrzahl von Werkstückträgern vorgesehen sein, die jeweils zur Durchführung eines Druckvorgangs innerhalb der Druckeinrichtung positionierbar sind. Hierzu können die Werkstückträger durch die Transporteinrichtung automatisiert transportierbar sein, insbesondere gleichzeitig entlang unterschiedlicher Abschnitte der Transporteinrichtung transportierbar sein. Die Produktivität der Vorrichtung lässt sich hierdurch weiter verbessern.

Zumindest einer der Werkstückträger kann individuell und/oder verfolgbar gekennzeichnet sein. Bevorzugt sind sämtliche Werkstückträger individuell und/oder verfolgbar gekennzeichnet. Durch eine derartige Kennzeichnung können sämtliche Prozessschritte bezüglich eines Werkstückträgers nachvollzogen und/oder automatisiert festgehalten beziehungsweise dokumentiert werden.

Unterschiedliche Stationen der Vorrichtung, beispielsweise die Druckeinrichtung und/oder eine Kühl- beziehungsweise Trocknungseinrichtung, können den jeweiligen Werkstückträger anhand einer Kennzeichnung erkennen und die jeweils in Bezug auf den Werkstückträger durchgeführten Prozessschritte speichern. Es kann somit in einer übergeordneten Datenstruktur jede in Bezug auf einen Werkstückträger durchgeführte Prozessabfolge nachvollzogen werden. Dies kann insbesondere für den Fall unterschiedlicher Druckeinrichtungen bei Nutzung einer gemeinsamen Trocknungseinrichtung von Vorteil sein.

Es besteht beispielsweise die Möglichkeit, dass an unterschiedlichen Druckstationen unterschiedliche Werkstücke beziehungsweise Werkstückarten erzeugt werden, gegebenenfalls mit unterschiedlichen Materialrezepturen und/oder Schichtdicken und/oder Drucksieben. Die jeweils verwendeten Materialrezepturen und/oder Schichtdicken können wiederum Einfluss auf den erforderlichen Trocknungsprozess haben, sodass für die Trocknung unterschiedlicher Siebdruckwerkstücke auf unterschiedlichen Werkstückträgern jeweils der Trocknungsprozess individuell anpassbar ist beziehungsweise abwechselnd umgestellt werden kann. Neben der Betriebssicherheit wird somit auch die Betriebsflexibilität durch eine entsprechende Kennzeichnung der Werkstückträger verbessert.

Gemäß einer weiter bevorzugten Ausgestaltung ist der zumindest eine Werkstückträger mit wenigstens einer Markierung, bevorzugt mit einer Mehrzahl von Markierungen, versehen. Eine solche Markierung kann bevorzugt elektronisch, insbesondere per RFID, optisch und/oder per Kamera erkennbar sein. Die Prozesssicherheit lässt sich auf diese Weise weiter verbessern, da über die eine solche Markierung die laufende oder sich wiederholende Informationsgewinnung in Bezug auf den jeweiligen Werkstückträger vereinfacht wird.

Gemäß einer weiter bevorzugten Ausgestaltung ist der zumindest eine Werkstückträger mit wenigstens einer Markierung zur individuellen Kennzeichnung und/oder individuellen Nachverfolgung des Werkstückträgers versehen, insbesondere mit einer Individualkennzeichnung zur Nachverfolgung. Eine solche Markierung kann demnach eine elektronische und/oder optische Kennung aufweisen, anhand derer sich der jeweilige Werkstückträger nachverfolgen lässt.

Gemäß einer weiter bevorzugten Ausgestaltung ist der zumindest eine Werkstückträger mit wenigstens einer Markierung zur Lageerfassung, insbesondere einer Mehrzahl von Markierungen zur Lageerfassung, versehen. Die Markierung zur Lageerfassung ist bevorzugt eine Markierung, über die die Position und/oder Ausrichtung des Werkstückträgers detektierbar ist. Insbesondere ist eine solche Markierung optisch detektierbar. Es können bevorzugt zwei Markierungen zur Lageerfassung pro Werkstückträger vorgesehen sein, wodurch die Position und/oder Ausrichtung des jeweiligen Werkstückträgers mit hoher Sicherheit ermittelt werden kann. Insbesondere kann jeweils eine Markierung durch eine jeweils zugeordnete Erfassungseinrichtung, insbesondere Kamera, erfasst werden, die nachfolgend noch näher beschrieben wird. Beispielsweise können zwei Kameras vorgesehen sein, die jeweils zur Erfassung einer der Markierungen auf einem zu erfassenden Werkstückträger eingerichtet sind.

Gemäß einer weiter bevorzugten Ausgestaltung weist der Werkstückträger eine durch eine Lageerfassungseinrichtung und/oder durch eine Positionier- und/oder Handhabungseinrichtung und/oder eine Transporteinrichtung detektierbare Markierung auf. Die Erfassungssicherheit beziehungsweise Erfassungsgeschwindigkeit kann auf diese Weise verbessert werden. Sowohl die Handhabung des Werkstückträgers als auch die Positions- und Ausrichtungsfeineinstellung der Drucktischplatte beziehungsweise des Druckoberwerks kann auf diese Weise vereinfacht werden.

Gemäß einer weiter bevorzugten Ausgestaltung ist wenigstens eine Speichereinrichtung, insbesondere ein Ein- und/oder Ausgabespeicher, vorgesehen, der zum temporären Speichern und/oder automatisierten Aufnehmen und/oder Ausgeben wenigstens eines Werkstückträgers, bevorzugt einer Mehrzahl von Werkstückträgern, ausgebildet sein kann. Durch eine derartige Speichereinrichtung können einzelne Werkstückträger gezielt aus dem Produktionsprozess ausgeschleust und/oder in diesen wieder eingeschleust werden, beispielsweise um weitere Durchläufe von anderen Werkstückträgern innerhalb der Vorrichtung abzuwarten. Beispielsweise können Werkstückträger aus dem Produktionsprozess ausgeschleust und in der Speichereinrichtung temporär gespeichert werden, bis ein Siebwechsel in der Druckeinrichtung erfolgt ist. Nach erfolgtem Siebwechsel kann dann der jeweilige Werkstückträger aus der Speichereinrichtung wieder in den Produktionsprozess eingeschleust werden und dann zum jeweils gewünschten Zeitpunkt in die mit dem neuen Sieb ausgestattete Druckeinrichtung zugeführt werden. Die Fertigungsflexibilität beziehungsweise Effizienz kann auf diese Weise verbessert werden.

In einer weiter bevorzugten Ausgestaltung kann die Transporteinrichtung für den automatisierten Transport des wenigstens einen Werkstückträgers ausgebildet sein, bevorzugt für eine Mehrzahl von Werkstückträgern, zwischen der Druckeinrichtung und der Kühleinrichtung und/oder zwischen der Trocknungseinrichtung und dem Ein- und/oder Ausgabespeicher und/oder zwischen Ein- und/oder Ausgabespeicher und der Druckeinrichtung. Eine derartige Transportverbindung zwischen den einzelnen Einrichtungen beziehungsweise Stationen der Vorrichtung kann insbesondere einen Kreislauf bilden. Durch einen derartigen Transportkreislauf kann ein besonders günstiger Materialfluss zwischen der Druckeinrichtung, der Trocknungseinrichtung und/oder der Speichereinrichtung sichergestellt werden. Das Erfordernis der manuellen Handhabung einzelner Werkstückträger kann hierdurch auf ein Minimum reduziert oder vollständig vermieden werden.

Gemäß einer weiter bevorzugten Ausgestaltung kann die Transporteinrichtung und/oder der Transportkreislauf mehrspurig durch die Trocknungseinrichtung führen. Ferner kann in der Transporteinrichtung beziehungsweise im Transportkreislauf die Rückführung von der Trocknungseinrichtung zur Druckeinrichtung einspurig ausgestaltet sein. Es können weniger Spuren in dem von der Trocknungseinrichtung zur Druckeinrichtung rückführenden Transportabschnitt vorgesehen sein als in dem durch die Trocknungseinrichtung führenden Transportabschnitt. Hierdurch kann bei verhältnismäßig kurzer Länge der Trocknungseinrichtung eine große Trocknungskapazität bereitgestellt werden.

Weiter bevorzugt kann die Transporteinrichtung beziehungsweise der Transportkreislauf einen Überbrückungsabschnitt zur Überbrückung der Druckeinrichtung aufweisen. Der Transportkreislauf kann zum mehrmaligen Durchlaufen der Trocknungseinrichtung durch einen Werkstückträger ausgebildet sein, insbesondere ohne Durchlaufen der Druckeinrichtung. Dementsprechend kann ein Werkstückträger vor der Rückführung zur Druckeinrichtung mehrmals durch die Trocknungseinrichtung geführt werden, um ein hohes Maß an Trocknung sicherzustellen.

Gleichzeitig kann ein unnötiges Durchlaufen der Druckeinrichtung durch Werkstückträger vermieden werden, wodurch die Produktivität weiter verbessert wird.

Gemäß einer weiter bevorzugten Ausgestaltung kann angrenzend an einen Druckbereich der Druckeinrichtung ein Inspektionsbereich vorgesehen sein, insbesondere zur Inspektion eines Siebdruckwerkstücks und/oder eines Werkstückträgers und/oder zur Inspektion einer Relativposition und/oder Relativausrichtung eines Werkstückträgers auf der Drucktischplatte und/oder zur Inspektion einer Relativposition und/oder Relativausrichtung eines Siebdruckwerkstücks auf einem Werkstückträger. Unter Druckbereich soll hier ein Areal verstanden werden, innerhalb dessen Druckvorgänge durch die Druckeinrichtung vorgenommen werden können. Ein gegenüber dem Druckbereich gesonderter Inspektionsbereich kann besonders auf etwaige Inspektionsprozesse ausgerichtet sein und damit eine hohe Prozessgenauigkeit begünstigen. Zudem kann eine gute Zugänglichkeit im Inspektionsbereich gewährleistet werden, auch für gegebenenfalls erforderliche Inspektionen durch Bedienpersonal.

Ein Inspektionsbereich kann in weiter bevorzugter Weise als Teil der Druckeinrichtung und/oder als Teil der Transporteinrichtung ausgebildet sein. Hierdurch ergibt sich ein hohes Maß an Anlagenintegration.

Gemäß einer bevorzugten Ausgestaltung weist die Druckeinrichtung eine Traganordnung, insbesondere ein Gestell, für die Drucktischplatte auf. Die Drucktischplatte kann durch die Traganordnung demnach getragen werden. Eine solche Traganordnung beziehungsweise ein solches Gestell kann beispielsweise durch Stützfüße oder auch durch einen Stützrahmen zur Abstützung der Drucktischplatte gegenüber einer Bodenfläche ausgestaltet sein.

Die Drucktischplatte kann relativ zur Traganordnung unbeweglich, insbesondere fixiert, sein. Auf diese Weise kann eine besonders robuste Ausgestaltung mit nur geringem konstruktivem Aufwand bewerkstelligt werden.

Ebenso ist es möglich, dass eine Beweglichkeit der Drucktischplatte relativ zur Traganordnung vorgesehen ist. Eine solche Beweglichkeit kann begrenzt sein auf einen Druckbereich der Druckeinrichtung. Wie voranstehend erwähnt, kann unter einem Druckbereich ein Areal verstanden werden, innerhalb dessen Druckvorgänge durch die Druckeinrichtung vorgenommen werden können. Bewegungen der Drucktischplatte in Positionen, in denen auf der Drucktischplatte keine Druckvorgänge vorzunehmen sind, können somit ausgeschlossen sein. Der konstruktive Aufwand hinsichtlich der Beweglichkeit der Drucktischplatte kann auf diese Weise begrenzt werden. Gleichzeitig wird durch eine verhältnismäßig geringe Beweglichkeit der Drucktischplatte ein Mindestmaß an Funktionalität sichergestellt werden.

Es ist ferner möglich, dass eine Beweglichkeit der Drucktischplatte lediglich in Druckaufbaurichtung gegeben ist. Eine solche Beweglichkeit kann in vorteilhafter Weise zur Einstellung des Absprungwertes zwischen dem Drucksieb und dem Werkstückträger beziehungsweise zur Einstellung der Distanz zwischen einer Unterseite des Drucksiebs und einer Oberseite eines Werkstücks beziehungsweise eines Druckguts dienen.

Unter Absprung soll vorliegend also die Distanz zwischen dem Drucksieb und dem Werkstückträger, auf dem ein Werkstück beziehungsweise ein Druckgut lagenweise erzeugbar ist, verstanden werden. Durch Veränderung des Absprungs kann demnach die Distanz zwischen der Unterseite des Drucksiebs und der Oberseite beziehungsweise einer Oberkante eines Werkstücks beziehungsweise Druckguts konstant gehalten werden.

Durch die Fixierung der Drucktischplatte relativ zur Traganordnung beziehungsweise durch Beschränkung der Beweglichkeit der Drucktischplatte auf einen Druckbereich können ferner Bewegungsmöglichkeiten der Drucktischplatte bis in eine Trocknungseinrichtung vermieden werden. Temperaturbelastungen der Drucktischplatte sowie etwaiger Antriebsmechanismen lassen sich auf diese Weise sicher reduzieren oder vollständig vermeiden.

Gemäß einer weiteren Ausgestaltung kann die Drucktischplatte als Schiebeplatte, insbesondere Wechselschiebeplatte, ausgebildet sein. Insbesondere können zwei Drucktischplatten der Druckeinrichtung als Schiebeplatten, insbesondere Wechselschiebeplatten, ausgebildet sein. Zwischen zwei unterschiedlichen Druckvorgängen kann demnach durch Verschiebeoperationen die jeweils gewünschte Drucktischplatte in Druckposition verbracht werden. Dementsprechend kann eine Beweglichkeit der Drucktischplatte auch über den Druckbereich hinaus und/oder bis zu einem außerhalb des Druckbereichs angeordneten Inspektionsbereich gegeben sein.

Gemäß einer weiteren Ausgestaltung der erfindungsgemäßen Vorrichtung weist die Druckeinrichtung ein Druckoberwerk auf. Ein solches Druckoberwerk kann insbesondere mit einem Druck- und/oder Flutrakel ausgestattet sein. Ebenso kann das Druckoberwerk ein Drucksieb und/oder eine Siebaufnahme und/oder einen Oberwerkrahmen aufweisen. Über das Druckoberwerk kann somit eine Druckpaste auf den jeweiligen Drucknutzen beziehungsweise weitere Druckpastenschichten auf das Werkstück oder Druckgut aufgetragen werden.

In bevorzugter Weise kann das Druckoberwerk und/oder das Drucksieb relativ zur Drucktischplatte und/oder relativ zur Traganordnung der Drucktischplatte beweglich angeordnet sein. Demnach kann beispielsweise das gesamte Druckoberwerk samt Drucksieb und gegebenenfalls weiteren Komponenten beweglich angeordnet sein. Ebenso kann eine Beweglichkeit des Drucksiebs innerhalb des Druckoberwerks vorgesehen sein, also beispielsweise relativ zu einem Oberwerkrahmen. Eine voranstehend beschriebene Beweglichkeit kann zur Einstellung für nachfolgende Druckoperationen genutzt werden und somit die Fertigungsflexibilität und Fertigungsgenauigkeit verbessern.

Ebenso kann das Druckoberwerk und/oder das Drucksieb relativ zur Drucktischplatte und/oder relativ zur Traganordnung der Drucktischplatte unbeweglich angeordnet sein. Hierdurch ergibt sich ein besonders robuster Aufbau. Eine unbewegliche Anordnung des Druckoberwerks und/oder das Drucksiebs ist besonders dann von Vorteil, wenn die Drucktischplatte relativ zur Traganordnung beweglich ist, um eine Relativbeweglichkeit zwischen Drucktischplatte und Oberwerk und/oder Drucksieb zu gewährleisten.

Ferner ist es möglich, dass eine Beweglichkeit des Druckoberwerks und/oder des Drucksiebs relativ zur Traganordnung und/oder relativ zur Drucktischplatte begrenzt ist auf einen Druckbereich der Druckeinrichtung. Eine solche Ausgestaltung kann insbesondere dann von Vorteil sein, wenn die Drucktischplatte relativ zur Traganordnung unbeweglich ist, sodass eine Relativbeweglichkeit zwischen Druckoberwerk und Drucktischplatte beziehungsweise Drucksieb und Drucktischplatte sichergestellt werden kann, wie voranstehend erwähnt. Bei einer Beweglichkeit des Drucksiebs relativ zur Drucktischplatte kann das Drucksieb insbesondere innerhalb des Druckoberwerks beweglich sein. Insbesondere kann eine Beweglichkeit begrenzt sein auf einen Druckbereich.

In weiter bevorzugter Weise kann die Druckeinrichtung zur Feineinstellung eingerichtet und/oder ausgebildet sein.

Unter Feineinstellung kann vorliegend eine Einstellung mit einer Genauigkeitstoleranz von +/- 10 µm betreffend die Position und/oder von bis zu +/- 0,05° betreffend die Ausrichtung beziehungsweise Rotationslage verstanden werden.

Ebenso kann unter Feineinstellung vorliegend eine Einstellung mit einer Genauigkeitstoleranz von +/- 5 µm betreffend die Position und/oder von bis zu +/- 0,03° betreffend die Ausrichtung beziehungsweise Rotationslage verstanden werden.

Ebenso kann unter Feineinstellung vorliegend eine Einstellung mit einer Genauigkeitstoleranz von +/- 2 µm betreffend die Position und/oder von bis zu +/- 0,02° betreffend die Ausrichtung beziehungsweise Rotationslage verstanden werden.

Ebenso kann unter Feineinstellung vorliegend eine Einstellung mit einer Genauigkeitstoleranz von +/- 1 µm betreffend die Position und/oder von bis zu +/- 0,01 ° betreffend die Ausrichtung beziehungsweise Rotationslage verstanden werden.

Ebenso kann unter Feineinstellung vorliegend eine Einstellung mit einer Genauigkeitstoleranz von +/- 0,5 µm betreffend die Position und/oder von bis zu +/- 0,005° betreffend die Ausrichtung beziehungsweise Rotationslage verstanden werden.

Die voranstehend erwähnten Genauigkeitstoleranzen betreffend die Feineinstellung können sich auf alle nachfolgend erwähnten Arten der Feineinstellung und/oder der dazu jeweils erforderlichen Stellantriebe beziehen.

In bevorzugter Weise kann die Druckeinrichtung zur Feineinstellung zwischen zwei aufeinanderfolgenden Druckvorgängen für ein Siebdruckwerkstück und/oder zur Feineinstellung zwischen dem Aufbringen aufeinanderfolgender Drucklagen oder Druckschichten für ein Siebdruckwerkstück eingerichtet und/oder ausgebildet sein. Die Prozess- und/oder Werkstückgenauigkeit lässt sich auf diese Weise erhöhen.

Bei einer Feineinstellung kann es sich bevorzugt um die Einstellung der Relativposition und/oder Relativausrichtung, insbesondere Rotationslagenausrichtung, zwischen der Drucktischplatte und dem Druckoberwerk beziehungsweise zwischen der Drucktischplatte und dem Drucksieb handeln. Ebenso kann es sich bei einer Feineinstellung um die Einstellung der Relativposition und/oder Relativausrichtung, insbesondere Rotationslagenausrichtung, zwischen dem Werkstückträger und dem Druckoberwerk und/oder zwischen dem Werkstückträger und dem Drucksieb handeln. Die Wiederholgenauigkeit für den Druck aufeinanderfolgender Drucklagen oder Druckschichten kann auf diese Weise weiter verbessert werden. Zudem können durch eine Feineinstellung komplexere Strukturen beziehungsweise Geometrien gefertigt werden. Für die Feineinstellung kann ein Stellantrieb oder auch eine Mehrzahl von Stellantrieben vorgesehen sein.

Gemäß einer weiter bevorzugten Ausgestaltung kann das Druckoberwerk und/oder das Drucksieb zur Positionsfeineinstellung relativ zur Traganordnung und/oder relativ zur Drucktischplatte in Richtung quer durch Druckaufbaurichtung verfahrbar sein. Ebenso kann vorgesehen sein, dass das Druckoberwerk und/oder das Drucksieb zur Ausrichtungsfeineinstellung, insbesondere Rotationslagenfeineinstellung, um eine in Druckaufbaurichtung verlaufende Rotationsachse rotierbar ist. Zur Positions- und/oder Ausrichtungsfeineinstellung, insbesondere Rotationslagenfeineinstellung, des Druckoberwerks und/oder des Drucksiebs kann zumindest eine Stelleinrichtung vorgesehen sein, bevorzugt eine Mehrzahl von Stelleinrichtungen.

Bei der Druckaufbaurichtung handelt es sich um eine Richtung in der die jeweiligen Druckschichten aufeinanderfolgend angeordnet sind. Die Druckaufbaurichtung wird vorzugsweise auch als Z-Achse bezeichnet. Die Richtungen quer zur Druckaufbaurichtung werden dementsprechend auch als X-Achse beziehungsweise Y-Achse bezeichnet. Durch eine Positionsfeineinstellung in Richtung quer zur Druckaufbaurichtung wird dementsprechend eine translatorische Bewegung des Druckoberwerks und/oder des Drucksiebs, insbesondere relativ zur Traganordnung und/oder relativ zur Drucktischplatte, ermöglicht. Durch Rotation des Druckoberwerks und/oder des Drucksiebs um eine in Druckaufbaurichtung verlaufende Rotationsachse, bei der es sich um eine Z-Achse handeln kann, ist zudem eine Ausrichtung des Druckoberwerks und/oder des Drucksiebs möglich.

Gemäß einer weiter bevorzugten Ausgestaltung kann die Drucktischplatte zur Positionsfeineinstellung relativ zur Traganordnung in Richtung quer zur Druckaufbaurichtung verfahrbar sein. Ebenso kann die Drucktischplatte zur Ausrichtungsfeineinstellung, insbesondere Rotationslagenfeineinstellung, um eine in Druckaufbaurichtung verlaufende Rotationsachse rotierbar sein. Es kann folglich anstelle der Bewegung beziehungsweise Rotation des Druckoberwerks und/oder des Drucksiebs zur Positionsfeineinstellung auch eine entsprechende Bewegung beziehungsweise Ausrichtung der Drucktischplatte erfolgen. Insbesondere kann die Drucktischplatte und damit auch der auf der Drucktischplatte angeordnete Werkstückträger im Raum translatorisch bewegt und/oder rotiert werden kann.

Zur Positions- und/oder Ausrichtungsfeineinstellung der Drucktischplatte kann in bevorzugter Weise zumindest eine Stelleinrichtung vorgesehen sein. Ebenso können mehrere Stelleinrichtungen vorgesehen sein, beispielsweise für jede Bewegungsachse einer Stelleinrichtung. Schließlich ist es auch möglich, dass zur Positions- und oder Ausrichtungsfeineinstellung sowohl die Drucktischplatte als auch das Druckoberwerk beziehungsweise das Drucksieb verfahrbar beziehungsweise rotierbar angeordnet sind.

Durch die Möglichkeiten der Positions- und/oder Ausrichtungsfeineinstellung kann die Fertigungspräzision weiter erhöht werden. Durch das Lösen des Werkstückträgers von der Drucktischplatte im Zuge des Siebdruckprozesses ist eine wiederkehrende Positionierung des Werkstückträgers auf der Drucktischplatte erforderlich. Einerseits kann nun durch präzise Positionierung beziehungsweise Ausrichtung des Werkstückträgers auf der Drucktischplatte bereits ein hohes Maß an Genauigkeit im Siebdruckprozess sichergestellt werden. Durch die Möglichkeit der Positions- und oder Ausrichtungsfeineinstellung des Druckoberwerks, des Drucksiebs und/oder der Drucktischplatte kann die Fertigungsflexibilität und/oder Fertigungsgenauigkeit weiter verbessert werden.

In weiter bevorzugter Weise kann das Druckoberwerk und/oder das Drucksieb zur Einstellung einer Absprunghöhe relativ zur Traganordnung und/oder relativ zur Drucktischplatte in einer Druckaufbaurichtung verfahrbar sein. Hierdurch lässt sich wiederum die Fertigungsflexibilität und/oder Fertigungsgenauigkeit weiter verbessern. Ebenso kann auch die Drucktischplatte zur Einstellung einer Absprunghöhe relativ zur Traganordnung und/oder relativ zum Druckoberwerk und/oder relativ zum Drucksieb in einer Druckaufbaurichtung verfahrbar sein, wie voranstehend in Bezug auf die Möglichkeit der Bewegbaren Anordnung der Drucktischplatte erwähnt. Zur Einstellung einer Absprunghöhe kann zumindest eine Stelleinrichtung vorgesehen sein. Es kann insbesondere eine Stelleinrichtung zur Feineinstellung der Absprunghöhe vorgesehen sein.

Gemäß einer weiter bevorzugten Ausgestaltung ist wenigstens eine Lageerfassungseinrichtung für ein Siebdruckwerkstück und/oder für einen Werkstückträger und/oder für die Drucktischplatte vorgesehen. Es besteht ferner die Möglichkeit, dass eine Mehrzahl von Lageerfassungseinrichtungen vorgesehen ist, insbesondere unterschiedliche Lageerfassungseinrichtungen zur Lageerfassung unterschiedlicher Komponenten beziehungsweise zur Abdeckung unterschiedlicher Erfassungsbereiche.

In bevorzugter Weise kann eine Stelleinrichtung der Drucktischplatte und/oder eine Stelleinrichtung des Druckoberwerks dazu eingerichtet sein, eine Positions- und/oder Ausrichtungsfeineinstellung in Abhängigkeit einer Lageerfassung durch eine Lageerfassungseinrichtung vorzunehmen. Es kann ein Regelkreis implementiert sein, durch den eine Positionier- beziehungsweise Ausrichtungsfeineinstellung in besonders hoher Genauigkeit ermöglicht wird.

Gemäß einer bevorzugten Ausgestaltung kann eine oder die Lageerfassungseinrichtung dazu eingerichtet sein, die Position und/oder Ausrichtung eines Siebdruckwerkstücks und/oder des Werkstückträgers im Raum und/oder relativ zur Drucktischplatte und/oder relativ zu einer Traganordnung für die Drucktischplatte und/oder relativ zu einem Druckoberwerk zu erfassen. Ebenso kann eine oder die Lageerfassungseinrichtung dazu eingerichtet sein, die Position und/oder Ausrichtung der Drucktischplatte relativ zur Traganordnung zu erfassen. Es kann dementsprechend ein Regelkreis in Bezug auf die absolute Lage der Drucktischplatte im Raum beziehungsweise relativ zur Traganordnung implementiert werden.

Gemäß einer bevorzugten Ausgestaltung kann eine Lageerfassungseinrichtung dazu eingerichtet sein, die Position und/oder Ausrichtung eines Siebdruckwerkstücks relativ zu dem darunter angeordneten Werkstückträger zu erfassen. Die Prozess- und/oder Werkstückgenauigkeit lässt sich hierdurch weiter verbessern.

Ebenso kann eine Lageerfassungseinrichtung dazu eingerichtet sein, eine Lageerfassung eines Werkstückträgers mittels wenigstens einer Markierung, insbesondere mittels wenigstens zwei Markierungen, auf dem Werkstückträger vorzunehmen. Dies kann mit geringem Aufwand und verhältnismäßig hoher Genauigkeit erfolgen.

Weiterhin kann eine Lageerfassungseinrichtung zur Lageerfassung innerhalb eines Druckbereichs ausgebildet und/oder innerhalb eines Druckbereichs angeordnet sein. Es kann hierdurch eine hohe Prozess- und Anlagenintegration realisiert werden.

Ebenso kann eine Lageerfassungseinrichtung zur Lagerfassung außerhalb eines Druckbereichs ausgebildet sein, insbesondere innerhalb eines außerhalb des Druckbereichs angeordneten Inspektionsbereichs. Eine Lageerfassungseinrichtung kann ferner außerhalb des Druckbereichs und/oder innerhalb des Inspektionsbereichs angeordnet sein. Bauraumrestriktionen lassen sich somit vermeiden und eine insgesamt gute Zugänglichkeit beziehungsweise Einsehbarkeit für Bedienpersonal gewährleisten.

In weiter bevorzugter Weise kann die Lageerfassungseinrichtung wenigstens eine Kamera aufweisen, insbesondere eine unterhalb oder oberhalb der Drucktischplatte angeordnete Kamera. Die Drucktischplatte kann somit zwischen der Kamera und dem Druckoberwerk angeordnet sein. Ferner kann die Lageerfassungseinrichtung dazu eingerichtet sein, die Abdeckung zumindest einer Öffnung in der Drucktischplatte durch den Werkstückträger zu erfassen. Die Drucktischplatte kann demnach mit definierten Öffnungen, beispielsweise kreisförmigen Öffnungen, ausgestattet sein, welche durch einen Werkstückträger bei Positionierung auf der Drucktischplatte teilweise abgedeckt werden. Das Maß und die Form der Abdeckung dieser Öffnungen durch die Drucktischplatte kann durch eine Kamera erfasst werden und hieraus ein Rückschluss auf die Lage des Werkstückträgers auf der Drucktischplatte gezogen werden. Eine entsprechende Kamera kann auch oberhalb der Drucktischplatte angeordnet sein, beispielsweise an dem Druckoberwerk.

Ferner besteht die Möglichkeit, dass die Lageerfassungseinrichtung zur Lageerfassung des Werkstückträgers in einer von der Drucktischplatte beabstandeten Position eingerichtet ist. Die Lageerfassung des Werkstückträgers in einer von der Drucktischplatte beabstandeten Position kann insbesondere zum Einleiten eines Handhabungsprozesses dienen. So kann durch die Lageerfassung eine Positionier- und/oder Handhabungseinrichtung gezielt beziehungsweise mit hoher Sicherheit eine Kontaktierung beziehungsweise ein Greifen des Werkstückträgers realisieren und anschließend eine Repositionierung auf der Drucktischplatte vornehmen beziehungsweise ein gezieltes Transportieren oder Befördern bis auf die Drucktischplatte initiieren. Ebenso kann die Lageerfassungseinrichtung bei der Erfassung der Position und/oder Ausrichtung des Werkstückträgers relativ zur Drucktischplatte die Handhabung und/oder das Befördern des Werkstückträgers von der Drucktischplatte weg initiieren. Der Automatisierungsgrad lässt sich auf diese Weise weiter erhöhen, wodurch die Gesamtproduktivität der Vorrichtung weiter verbessert werden kann. Schließlich können für unterschiedliche Erfassungsfunktionen unterschiedliche Lageerfassungseinrichtungen vorgesehen sein, beispielsweise in Form von mehreren Kameras oder Kamerasystemen.

Gemäß einer weiter bevorzugten Ausgestaltung kann auch eine Lageerfassungseinrichtung für ein Drucksieb vorgesehen sein, insbesondere zur Erfassung der Position und/oder Ausrichtung eines Drucksiebs im Raum und/oder relativ zu einem Druckoberwerk und/oder relativ zum Oberwerkrahmen und/oder relativ zur Drucktischplatte und/oder relativ zu einer Traganordnung für die Drucktischplatte.

In weiter bevorzugter Ausgestaltung kann eine Höhenerfassungseinrichtung vorgesehen sein, insbesondere eine Höhenerfassungseinrichtung für ein Siebdruckwerkstück beziehungsweise für ein Druckgut. Eine solche Höhenerfassungseinrichtung kann die aktuelle Aufbauhöhe eines Siebdruckwerkstücks, welches auf dem Werkstückträger und/oder dem Drucktisch positioniert ist, erfassen. In Abhängigkeit der Höhenerfassung kann eine Absprunghöhe eingestellt werden. Die Höhenerfassung kann punktuell an einer repräsentativen Position des Siebdruckwerkstücks beziehungsweise des Druckgutes erfolgen. Die Höhenerfassungseinrichtung kann auch durch ein Kamerasystem ausgebildet sein. Insbesondere kann die Höhenerfassungseinrichtung gemeinsam mit der Lageerfassungseinrichtung als Einheit ausgebildet sein.

Gemäß einer weiter bevorzugten Ausgestaltung kann die Drucktischplatte zur temporären Fixierung des Werkstückträgers ausgebildet sein, insbesondere zur temporären Fixierung in definierter und/oder ausgerichteter Position auf der Drucktischplatte. Durch die Drucktischplatte kann somit die sichere Einhaltung der Position des Werkstückträgers für einen Druckvorgang gewährleistet werden. Gleichzeitig gewährleistet die temporäre Fixierbarkeit beziehungsweise Lösbarkeit des Werkstückträgers von der Drucktischplatte ein ausreichend hohes Maß an Flexibilität, insbesondere zur Beschickung der Drucktischplatte mit einer Mehrzahl von Werkstückträgern während des Produktionsprozesses.

Bei der Drucktischplatte kann es sich beispielsweise um eine Lochplatte handeln, insbesondere um eine Lochplatte zur Vakuumfixierung des Werkstückträgers. Durch eine derartige Ausgestaltung kann mit nur geringem Aufwand eine präzise und sichere Fixierung des Werkstückträgers auf der Drucktischplatte gewährleistet werden. Gleichzeitig ermöglicht eine Vakuumfixierung durch Aufhebung eines erzeugten Vakuums eine einfache Lösbarkeit des Werkstückträgers von der Drucktischplatte zwecks Bewegung oder Beförderung des Werkstückträgers in einen nachfolgenden Prozessschritt.

Bei der Drucktischplatte kann es sich insbesondere um eine formstabile beziehungsweise steife Platte handeln. Die Drucktischplatte kann beispielsweise 1 bis 10 cm dick, bevorzugt 2 cm bis 8 cm oder 3 cm bis 7 cm dick sein. Insbesondere kann die Drucktischplatte mit eine Dicke von etwa 5 cm aufweisen. Die Drucktischplatte kann aus einem verschleißbeständigen Material, insbesondere aus einem Metallwerkstoff, gefertigt sein.

Die Drucktischplatte kann insbesondere als Drucktischplatte mit Mehrfachnutzen ausgebildet sein. Dabei soll unter einem Drucknutzen diejenige Fläche verstanden werden, welche mittels der Druckeinrichtung bedruckbar ist.

Weiter bevorzugt kann die Druckeinrichtung eine Mehrzahl an Drucktischplatten aufweisen. Es können also abwechselnd unterschiedliche Drucktischplatten für einen Druck zum Einsatz kommen, wodurch Stillstandzeiten weiter reduziert werden können.

Gemäß einer weiteren vorteilhaften Ausgestaltung kann der Werkstückträger aus einem temperaturresistenten Werkstoff erzeugt sein und/oder als Aluminiumplatte ausgebildet sein, insbesondere als beidseitig eloxierte Aluminiumplatte. Der Werkstückträger kann auch abschnittsweise als Aluminiumplatte ausgebildet sein und in anderen Abschnitten aus einem anderen Werkstoff bestehen. Ebenso besteht die Möglichkeit, dass der Werkstückträger zumindest abschnittsweise aus einem keramischen Werkstoff erzeugt ist. Derartig ausgebildete Werkstückträger weisen eine nur geringe Neigung zur Deformation auf, sodass durch etwaige Trocknungsprozesse für die Siebdruckwerkstücke ein hohes Maß an Betriebssicherheit sichergestellt werden kann.

In weiter bevorzugter Weise kann der Werkstückträger eine Dicke von 1 mm bis 4 mm, bevorzugt von 1,5 mm bis 3 mm, insbesondere von 2 mm bis 2,5 mm oder von ca. 2 mm aufweisen. Einerseits weist ein derartiger Werkstückträger eine ausreichende Formstabilität und somit Langlebigkeit auf. Andererseits sind derart dimensionierte Werkstückträger ausreichend leicht, um durch eine Handhabungseinrichtung mit nur geringem Aufwand und mit ausreichender Genauigkeit positioniert werden zu können.

In weiter bevorzugter Weise kann die Vorrichtung und/oder die Druckeinrichtung der Vorrichtung eine Siebwechselvorrichtung aufweisen, insbesondere für den automatisierten Siebwechsel. Eine solche Siebwechselvorrichtung kann in vorteilhafter Weise ein vorhandenes Sieb aus einer Siebaufnahme des Druckoberwerks entnehmen und durch ein anderes Sieb austauschen. Hierzu kann die Siebwechselvorrichtung mit einem Magazin zur Speicherung einer Mehrzahl von Drucksieben ausgestattet sein.

In weiter bevorzugter Weise kann die Vorrichtung mehrere modular zu einem Vorrichtungssystem verbindbare Einrichtungen aufweisen. Insbesondere können mehrere Druckeinrichtungen und/oder mehrere Trocknungseinrichtungen vorgesehen sein. Ebenso können mehrere Speichereinrichtungen vorgesehen sein, sodass die Gesamtproduktivität und/oder Flexibilität der Vorrichtung weiter verbessert werden kann.

Weiter bevorzugt können die Druck-, Trocknungs- und/oder Speichereinrichtungen modular zu einem Vorrichtungssystem verbindbar sein. Insbesondere können mehrere Druckeinrichtungen und/oder mehrere Trocknungseinrichtungen und/oder mehrere Speichereinrichtungen modular zu einem Vorrichtungssystem verbindbar sein. Auf diese Weise lässt sich in besonders vorteilhafter Weise eine Anpassung an die jeweiligen Produktionsanforderungen vornehmen, ohne dass es einer vollständigen Neukonzeption bedarf.

Bei einer bereits konfigurierten Vorrichtung mit einer Druckeinrichtung, einer Trocknungseinrichtung und/oder einer Speichereinrichtung kann in vorteilhafter Weise eine zusätzliche Druckeinrichtung oder eine zusätzliche Trocknungseinrichtung oder auch eine zusätzliche Speichereinrichtung angeordnet beziehungsweise modular angeschlossen werden, um gegebenenfalls die Kapazitäten zu erhöhen und/oder die Funktionalitäten zu erweitern. Die Gesamtflexibilität wird auf diese Weise verbessert.

Ein weiterer Aspekt der vorliegenden Erfindung betrifft ein Verfahren zur Herstellung von dreidimensionalen Siebdruckwerkstücken, insbesondere mit einer voranstehend beschriebenen Vorrichtung.

Bei dem erfindungsgemäßen Verfahren wird in einer Druckeinrichtung ein Siebdruckwerkstück in mehreren Druckvorgängen schichtweise erzeugt und das Siebdruckwerkstück zwischen zwei aufeinanderfolgenden Druckvorgängen zur Trocknung durch eine Trocknungseinrichtung für den kontinuierlichen Trocknungsdurchlauf geführt. Dies gestattet einen insgesamt kontinuierlichen Produktionsprozess für eine Mehrzahl von Siebdruckwerkstücken beziehungsweise mit einer Mehrzahl von Werkstückträgern, auf denen Siebdruckwerkstücke angeordnet sein können. Sowohl das Bedrucken als auch das Trocknen kann durch einen kontinuierlichen Trocknungsdurchlauf im Wesentlichen unterbrechungsfrei vorgenommen werden, wodurch die Gesamtproduktivität der Vorrichtung gesteigert werden kann.

Die vorstehend in Bezug auf die Vorrichtung beschriebenen Einzelheiten gelten in gleicher Weise auch für das erfindungsgemäße Verfahren.

Nachfolgend wird die Erfindung beispielhaft anhand vorteilhafter Ausführungsformen unter Bezugnahme auf die beigefügten Figuren beschrieben. Es zeigen:
- Fig. 1: eine perspektivische Ansicht einer erfindungsgemäßen Vorrichtung gemäß einer Ausführungsform,
- Fig. 2: eine Draufsicht auf die Vorrichtung von Fig. 1,
- Fig. 3: eine schematische Draufsicht auf die Vorrichtung von Fig. 1 mit Darstellung einer oberen Transportebene,
- Fig. 4: eine schematische Draufsicht auf die Vorrichtung von Fig. 1 mit Darstellung einer unteren Transportebene.

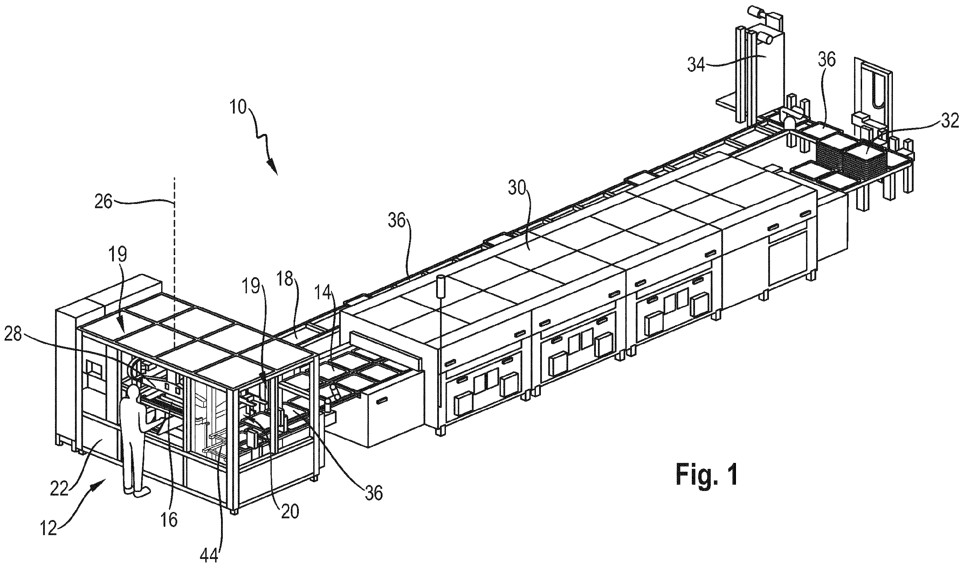

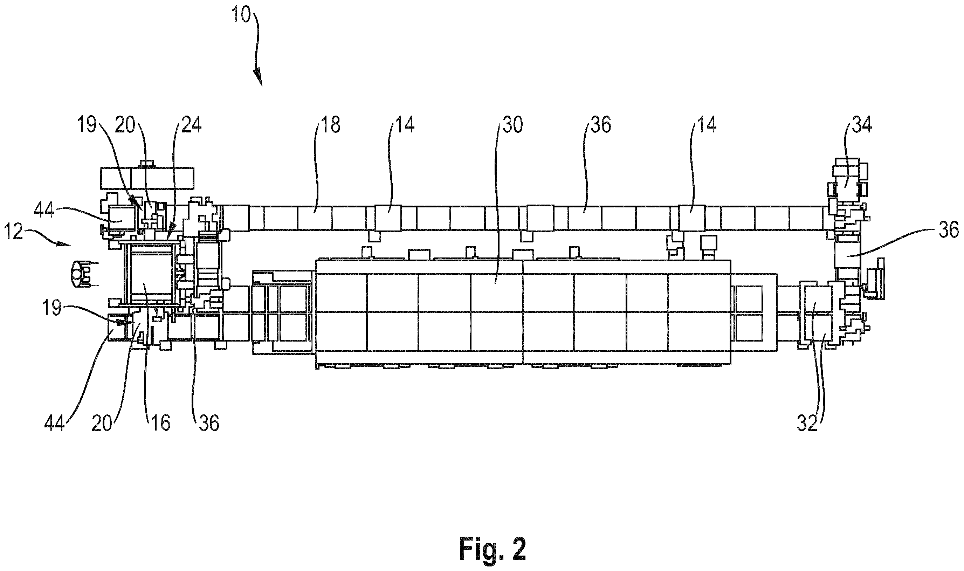

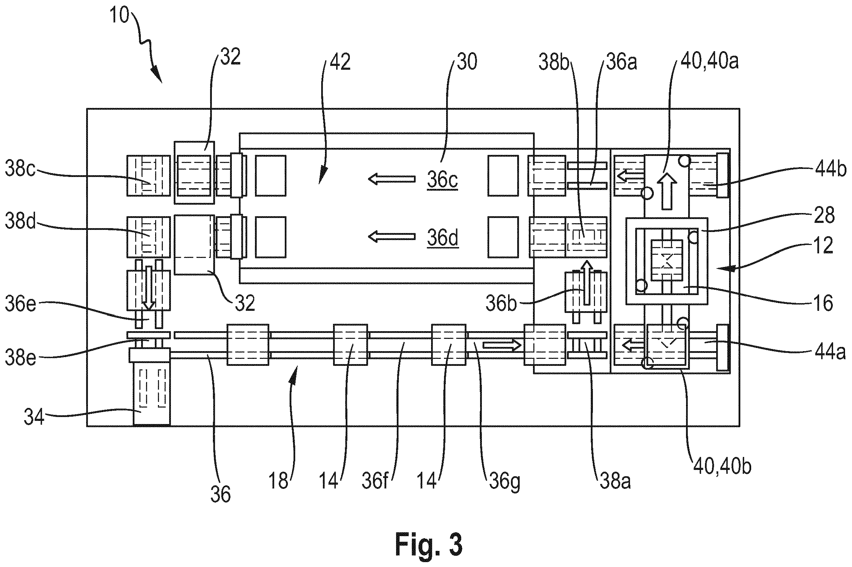

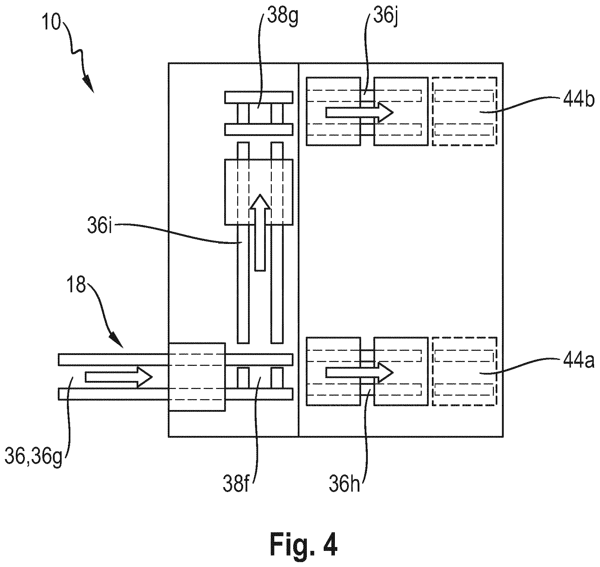

Die Fig. 1 zeigt eine perspektivische Ansicht einer erfindungsgemäßen Vorrichtung 10 zur Herstellung von dreidimensionalen Siebdruckwerkstücken gemäß einer Ausführungsform. Die Fig. 2 zeigt eine Draufsicht auf die Vorrichtung 10 von Fig. 1. Fig. 3 und 4 zeigen schematisch eine Draufsicht auf die Vorrichtung 10 mit Darstellung unterschiedlicher Transportebenen.

Die Vorrichtung 10 weist eine Druckeinrichtung 12 für die schichtweise Erzeugung zumindest eines Siebdruckwerkstücks in mehreren Druckvorgängen auf. Bei der Druckeinrichtung 12 kann es sich um einen sogenannten Siebdrucker handeln. Ferner weist die Vorrichtung 10 eine Mehrzahl von Werkstückträgern 14 auf. Die Werkstückträger 14 sind für zumindest ein Siebdruckwerkstück, bevorzugt für eine Mehrzahl von Siebdruckwerkstücken konzipiert. Dementsprechend kann auf einem einzelnen Werkstückträger 14 ein einzelnes Siebdruckwerkstück oder auch eine Mehrzahl von Siebdruckwerkstücken schichtweise erzeugt werden.

Ferner weist die Druckeinrichtung 12 wenigstens eine von dem Werkstückträger 14 gesondert ausgebildete Drucktischplatte 16 auf. Es können in der Druckeinrichtung 12 auch zwei oder mehr Drucktischplatten 16 vorgesehen sein. Bei zwei oder mehr Drucktischplatten 16 können diese jeweils als Wechselschiebetisch ausgebildet sein. Auch im Falle einer Drucktischplatte 16 kann diese als Wechselschiebetisch ausgebildet sein.

Der Werkstückträger 14 kann zur Durchführung eines Druckvorgangs auf der Drucktischplatte 16 positioniert werden. Zwischen zwei aufeinanderfolgenden Druckvorgängen kann der jeweilige Werkstückträger 14 zur Trocknung des Siebdruckwerkstücks von der Drucktischplatte 16 lösbar sein. Die Vorrichtung 10 kann demzufolge dazu konzipiert sein, dass jeder Werkstückträger 14 zwischen zwei aufeinanderfolgenden Druckvorgängen zur Trocknung des darauf befindlichen Siebdruckwerkstücks von der Drucktischplatte 16 lösbar ist. Zur Erzeugung eines einzelnen Siebdruckwerkstücks wird der jeweilige Werkstückträger 14 somit mehrmals auf der Drucktischplatte 16 positioniert und wieder von dieser entfernt. Die Auslastung der Druckeinrichtung 12 kann auf diese Weise vorteilhaft verbessert werden. Zudem kann das Siebdruckwerkstück beziehungsweise das Druckgut zwischen unterschiedlichen Druckvorgängen auf dem jeweiligen Werkstückträger 14 verbleiben, sodass die Gefahr von Beschädigungen verringert wird.

Die Vorrichtung 10 kann ferner eine Transporteinrichtung 18 für den automatisierten Transport wenigstens eines Werkstückträgers 14, insbesondere für eine Mehrzahl von Werkstückträgern 14, aufweisen. Die Transporteinrichtung 18 ist als Transportkreislauf für den automatisierten Transport des wenigstens einen Werkstückträgers 14, bevorzugt für eine Mehrzahl von Werkstückträgern 14, ausgebildet. Dabei ist die Transporteinrichtung 18 insbesondere für den automatisierten Transport im Kreislauf zwischen der Druckeinrichtung 12 und wenigstens einer von der Druckeinrichtung 12 und/oder der Drucktischplatte 16 beabstandeten Position eingerichtet ist.

Die Transporteinrichtung 18 kann zumindest abschnittsweise mehrspurig und/oder zumindest abschnittsweise einspurig ausgebildet sein, was bezugnehmend auf die Fig. 3 und 4 noch näher erläutert wird. Die Transporteinrichtung 18 ist zumindest abschnittsweise durch ein Fördermittel, insbesondere einen Bandförderer, gebildet. Unterschiedliche Transportstrecken der Transporteinrichtung 18 können unter einem Winkel zueinander verlaufen. Hierzu können Eckumsetzer vorgesehen sein.

Die Vorrichtung 10 kann ferner mit einer Positionier- und/oder Handhabungseinrichtung 20 ausgestattet sein, durch die ein Werkstückträger 14 automatisiert und/oder definiert auf der Drucktischplatte 16 positionierbar ist. Die Positionier- und/oder Handhabungseinrichtung 20 kann als Teil der Transporteinrichtung 18 ausgebildet sein.

Eine Positioniereinrichtung 20 kann beispielsweise ein Fördermittel aufweisen, insbesondere Bandförderer. Ein solches Fördermittel kann bis in die Drucktischplatte 16 hinein verlaufen und/oder in der Drucktischplatte 16 eingelassen und/oder relativ zur Drucktischplatte 16 absenkbar und/oder anhebbar sein. Auf diese Weise kann ein Werkstückträger 14 bis über die Drucktischplatte 16 befördert und dann in geeigneter Weise abgesetzt und wieder angehoben und wegbefördert werden.

Bei einer Handhabungseinrichtung, die hier nicht näher dargestellt ist, kann es sich beispielsweise um eine Pick-and-Place-Einrichtung beziehungsweise um einen Handhabungsroboter handeln. Insbesondere kann durch eine Handhabungseinrichtung ein Werkstückträger 14 aus einem der Druckeinrichtung 12 vorgelagerten Bereich kontaktiert, angehoben und anschließend auf der Drucktischplatte 16 der Druckeinrichtung positioniert werden. Im Anschluss an einen Druckvorgang kann durch die Handhabungseinrichtung der jeweilige Werkstückträger wieder von der Drucktischplatte 16 angehoben und von der Druckeinrichtung 12 wegbefördert werden.

Die Positionier- und/oder Handhabungseinrichtung 20 kann ferner zur Lageerkennung des Werkstückträgers 14 ausgebildet sein. Hierzu kann an der Positionier- und/oder Handhabungseinrichtung 20 beispielsweise ein Kamerasystem 19 oder dergleichen vorgesehen sein, durch das eine Erkennung des Werkstückträgers 14 vor der Kontaktierung beziehungsweise vor dem Anheben vorgenommen werden kann. Durch eine derartige Lageerkennung des Werkstückträgers 14 wird insbesondere die Kontaktierung beziehungsweise das Anheben durch Förderbänder oder das Greifen des Werkstückträgers 14 durch eine Handhabungseinrichtung vereinfacht beziehungsweise die Beförderungs- und/oder Handhabungssicherheit erhöht. Eine solche Lageerkennung des Werkstückträgers 14 kann insbesondere in einem Inspektionsbereich erfolgen, auf den nachstehend noch eingegangen wird.

Ferner kann auch eine Ausrichteinrichtung vorgesehen sein, durch die der Werkstückträger 14 auf der Drucktischplatte 16 ausgerichtet und/oder definiert positionierbar ist. Bei der Ausrichteinrichtung kann es sich bevorzugt um die Positionier- und/oder Handhabungseinrichtung 20 handeln. Ebenso kann die Ausrichteinrichtung durch ein hier nicht näher dargestelltes mechanisches Positionierelement und/oder durch einen hier nicht näher dargestellten Anschlag gebildet sein.

Die Drucktischplatte 16 kann zur temporären Fixierung des Werkstückträgers 14 ausgebildet sein. Hierzu kann die Drucktischplatte 16 beispielsweise als Lochplatte ausgebildet sein, insbesondere als Lochplatte zur Vakuumfixierung des Werkstückträgers 14.

Die Druckeinrichtung 12 kann ferner eine Traganordnung 22 für die Drucktischplatte 16 aufweisen. Die Drucktischplatte 16 wird somit durch die Traganordnung 22 getragen. Dabei kann die Drucktischplatte 16 relativ zur Traganordnung 22 unbeweglich sein.

Ebenso kann eine Beweglichkeit der Drucktischplatte 16 vorgesehen sein. Eine Beweglichkeit der Drucktischplatte 16 relativ zur Traganordnung 22 kann dabei begrenzt sein auf einen Druckbereich 24 der Druckeinrichtung 12 und/oder zur Positions- beziehungsweise Ausrichtungsfeineinstellung der Drucktischplatte 16 vorgesehen sein. Es kann sich dabei um eine Positionsfeineinstellung relativ zur Traganordnung 22 in Richtung quer zur Druckaufbaurichtung 26 und/oder um eine Ausrichtungsfeineinstellung um eine in Druckaufbaurichtung 26 verlaufende Rotationsachse handeln. Die Druckaufbaurichtung 26 beziehungsweise die in Druckaufbaurichtung 26 verlaufende Rotationsachse verläuft, wie in Fig. 1 dargestellt, vertikal.

Ferner ist es möglich, dass eine Beweglichkeit der Drucktischplatte 16 relativ zur Traganordnung 22 über einen Druckbereich 24 der Druckeinrichtung 12 hinausgeht. Eine derartige Beweglichkeit kann jedoch zumindest auf ein Gehäuse und/oder eine Einfassung der Druckeinrichtung 12 begrenzt sein. Insbesondere kann die Beweglichkeit der Drucktischplatte 16 relativ zur Traganordnung 22 begrenzt sein auf Bereiche außerhalb einer Trocknungseinrichtung, die nachfolgend noch näher beschrieben wird. Ebenso kann eine Beweglichkeit der Drucktischplatte 16 relativ zur Traganordnung 22 bis hin in einen Inspektionsbereich gegeben sein, auf den noch näher eingegangen wird.

Ferner kann eine Beweglichkeit der Drucktischplatte 16 in Höhenrichtung entlang der Druckaufbaurichtung 26 vorgesehen sein, um eine Anpassung der Absprunghöhe für nachfolgende Druckvorgänge vorzunehmen.

Die Druckeinrichtung 12 kann ferner mit einem Druckoberwerk 28 ausgestattet sein. Das Druckoberwerk 28 kann ein Druck- und oder Flutrakel aufweisen, was hier nicht näher dargestellt ist. Ebenso kann das Druckoberwerk 28 mit wenigstens einem Drucksieb und/oder einer Siebaufnahme ausgestattet sein, was hier ebenfalls nicht näher dargestellt ist.

Das Druckoberwerk 28 beziehungsweise ein Rahmen des Druckoberwerks 28 kann relativ zur Drucktischplatte 16 und/oder relativ zur Traganordnung 22 unbeweglich sein. Hingegen kann eine Siebaufnahme des Druckoberwerks 28 relativ zu einem Rahmen des Druckoberwerks 28 und/oder relativ zur Drucktischplatte 16 und/oder relativ zur Traganordnung 22 beweglich sein. Eine solche Beweglichkeit der Siebaufnahme kann begrenzt sein auf einen Druckbereich 24 der Druckeinrichtung 12. Eine entsprechende Beweglichkeit der Siebaufnahme kann zur Positions- beziehungsweise Ausrichtungsfeineinstellung vorgesehen sein. Dies ist insbesondere dann von Vorteil, wenn die Drucktischplatte 16 relativ zur Traganordnung 22 unbeweglich angeordnet ist.

Ebenso kann eine Beweglichkeit der Siebaufnahme samt Drucksieb entlang der Druckaufbaurichtung 26 vorgesehen sein, um eine Anpassung des Absprungwertes für nachfolgende Druckvorgänge vorzunehmen. Hierzu kann eine nicht näher dargestellte Hubmechanik vorgesehen sein. Dies ist dann von Vorteil, wenn die Drucktischplatte 16 entlang der Druckaufbaurichtung 26 unbeweglich angeordnet ist.

Ferner kann zur Anpassung des Absprungwertes auch eine Beweglichkeit des gesamten Druckoberwerks 28 entlang der Druckaufbaurichtung 26 vorgesehen sein. Dies ist ebenfalls dann von Vorteil, wenn die Drucktischplatte 16 entlang der Druckaufbaurichtung 26 unbeweglich angeordnet ist.

Ebenso kann eine Beweglichkeit des Druckoberwerks 28 relativ zur Traganordnung 22 und/oder relativ zur Drucktischplatte 16 in Richtungen quer zur Druckaufbaurichtung 26 vorgesehen sein. Eine solche Beweglichkeit des gesamten Druckoberwerks 28 kann begrenzt sein auf einen Druckbereich 24 der Druckeinrichtung 12. Eine entsprechende Beweglichkeit des Druckoberwerks 28 kann zur Positions- beziehungsweise Ausrichtungsfeineinstellung des Druckoberwerks vorgesehen sein. Dies ist wiederum dann von Vorteil, wenn die Drucktischplatte 16 relativ zur Traganordnung 20 in Richtungen quer zur Druckaufbaurichtung 26 unbeweglich angeordnet ist.

Weiterhin kann eine hier nicht näher dargestellte Lageerfassungseinrichtung für ein Siebdruckwerkstück und/oder für einen Werkstückträger 14 und/oder für die Drucktischplatte 16 vorgesehen sein. Dabei können etwaige Stelleinrichtungen der Drucktischplatte 16 und/oder etwaige Stelleinrichtungen des Druckoberwerks 28 dazu eingerichtet sein, eine Positions- und/oder Ausrichtungsfeineinstellung in Abhängigkeit einer Lageerfassung durch die Lageerfassungseinrichtung vorzunehmen. Die Lageerfassungseinrichtung kann insbesondere eine Lageerfassung innerhalb des Druckbereichs 24 vornehmen. Ebenso ist es möglich, dass die Lageerfassungseinrichtung eine Lageerfassung außerhalb des Druckbereichs 24 vornimmt, beispielsweise in einem Inspektionsbereich. Es können ferner auch mehrere Lageerfassungseinrichtungen vorgesehen sein. Die Lageerfassungseinrichtung kann beispielsweise durch ein Kamerasystem oder dergleichen ausgebildet sein. Eine solche Lageerfassungseinrichtung kann insbesondere zur Lageerfassung von Werkstückträgern 14 eingerichtet sein.

Wie den Fig. 1 und 2 weiter entnommen werden kann, ist die Vorrichtung 10 mit einer Trocknungseinrichtung 30 ausgestattet. Bei der Trocknungseinrichtung 30 kann es sich um eine Trocknungsstrecke handeln. Die Trocknungseinrichtung 30 ist in Längsrichtung der Vorrichtung 10 hinter der Druckeinrichtung 12 angeordnet und kann eine aktive Länge aufweisen, die variabel einstellbar ist, beispielsweise durch Aktivierung und/oder Deaktivierung einzelner Wärmeerzeugungseinheiten, beispielsweise Konvektions- und/oder Wärmestrahlungseinheiten, die hier nicht näher dargestellt sind.

Bei der Vorrichtung 10 können die einzelnen Werkstückträger 14 unabhängig von der Drucktischplatte 16 durch die Trocknungseinrichtung 30 verfahrbar sein. Die Drucktischplatte 16 erfährt somit keine Temperaturbelastung.

Die Trocknungsstrecke der Trocknungseinrichtung 30 kann insbesondere für einen kontinuierlichen Trocknungsdurchlauf von Siebdruckwerkstücken und/oder Werkstückträgern 14 ausgebildet sein. Dabei kann die Verfahrgeschwindigkeit für die Werkstückträger 14 durch die Trocknungseinrichtung 30 variabel einstellbar sein.

Ebenso kann eine Trocknungseinrichtung vorgesehen sein, in der eine ruhende Trocknung von Siebdruckwerkstücken erfolgt. Hierzu können Werkstückträger samt Siebdruckwerkstücken in die Trocknungseinrichtung hinein und in entgegengesetzter Richtung wieder aus dieser heraus bewegt werden.

Die Vorrichtung 10 kann ferner einen Pufferspeicher 32 aufweisen, welcher der Trocknungseinrichtung 30 nachgelagert sein kann. In dem Pufferspeicher 32 kann eine weitere Trocknung beziehungsweise Nachtrocknung erfolgen. Durch den Pufferspeicher kann zudem Einfluss auf den Materialfluss innerhalb der Vorrichtung 10 genommen werden.

Ferner kann die Vorrichtung 10 mit einer Speichereinrichtung 34 ausgestattet sein, bei der es sich um einen Be- und/oder Entladespeicher beziehungsweise um einen Ein- und/oder Ausgabespeicher handeln kann. Über die Speichereinrichtung 34 können einzelne Werkstückträger 14 in die als Transportkreislauf ausgebildete Transporteinrichtung 18 ein- und aus dieser wieder ausgeschleust werden. In der Speichereinrichtung 34 kann auch eine temporäre Zwischenlagerung einzelner Werkstückträger 14 erfolgen. Die Speichereinrichtung 34 kann im Materialfluss zwischen der Trocknungseinrichtung 30 sowie der Druckeinrichtung 12 angeordnet sein.

Die Druckeinrichtung 12, die Trocknungseinrichtung 30, der Pufferspeicher 32 und/oder die Speichereinrichtung 34 können modular zu einem Vorrichtungssystem verbindbar sein. Ein solches Vorrichtungssystem kann aus einer Mehrzahl von Vorrichtungen 10 bestehen oder aus einer Vorrichtung 10, die um einzelne Einrichtungen oder Stationen erweitert und/oder reduziert worden ist.

Die Druckeinrichtung 12, die Trocknungseinrichtung 30, der Pufferspeicher 32 und/oder die Speichereinrichtung 34 können durch die Transporteinrichtung 18 in geeigneter Weise verbunden beziehungsweise zu einem Vorrichtungssystem integriert sein. Insbesondere kann durch die Transporteinrichtung 18 ein automatisierter Transport von Werkstückträgern zwischen der Druckeinrichtung 12, der Trocknungseinrichtung 30, dem Pufferspeicher 32 und/oder der Speichereinrichtung 34 erfolgen, insbesondere entlang eines Transportkreislaufs.

Der Transport von Werkstückträgern 14 durch die Transporteinrichtung 18 wird nun bezugnehmend auf die Fig. 3 und 4 erläutert, wobei Fig. 3 eine Draufsicht mit Darstellung einer oberen Ebene der Transporteinrichtung 18 und die Fig. 4 eine Draufsicht mit Darstellung einer unteren Ebene der Transporteinrichtung 18 zeigt. Die Transporteinrichtung 18 kann insbesondere eine Mehrzahl von Transportbandstrecken 36 sowie Eckumsetzern 38 aufweisen. Die Transportbandstrecken 36 können einzelne Werkstückträger 14 zwischen unterschiedlichen Stationen oder Einrichtungen der Vorrichtung 10 befördern.

Wie voranstehend erwähnt erfolgen die Druckvorgänge innerhalb der Druckeinrichtung 12. Hierzu müssen die jeweiligen Werkstückträger 14 innerhalb der Druckeinrichtung 12, insbesondere auf der Drucktischplatte 16 der Druckeinrichtung 12, positioniert sein.

Nach erfolgtem Druck wird der jeweilige Werkstückträger 14 aus der Druckeinrichtung 12 in einen im Materialfluss nachgeordneten Absetzbereich 40 positioniert. Dabei können beidseitig der Drucktischplatte 16 Absetzbereiche 40 vorgesehen sein. Die Werkstückträger 14 können demnach beidseitig von der Drucktischplatte 16 wegbefördert werden. Zwischen der Drucktischplatte 16 und dem jeweiligen Absetzbereich 40 kann eine Beförderung der Werkstückträger durch eine Positioniereinrichtung 20 vorgenommen werden, die ebenfalls durch eine Transportbandstrecke gebildet sein kann und einen Teil der Transporteinrichtung 18 bildet.

Ein vorstehend erwähnter Absetzbereich 40 kann insbesondere auch als Inspektionsbereich ausgebildet sein und/oder als Inspektionsbereich dienen.

Aus dem jeweiligen Absetzbereich 40 erfolgt eine Beförderung des jeweiligen Werkstückträgers 14 hin zur Trocknungseinrichtung 30. Dabei kann aus dem Absetzbereich 40a eine Beförderung der Werkstückträger 14 entlang der Transportbandstrecke 36a bis zur Trocknungseinrichtung 30 erfolgen. Ausgehend von dem Absetzbereich 40b erfolgt ein Beförderung der Werkstückträger bis zum Eckumsetzer 38a, weiter entlang der Transportbandstrecke 36b bis zum Eckumsetzer 38b und dann in die Trocknungseinrichtung 18 hinein. Ebenso kann vom Eckumsetzer 38b weiterbefördert werden bis zur Transportbandstrecke 36a und dann in die Trocknungseinrichtung 30 hinein.

Innerhalb der Trocknungseinrichtung 30 verläuft die Trocknungsstrecke 42. Die Trocknungsstrecke 42 kann zweispurig ausgebildet sein, also durch zwei Transportbandstrecken 36c und 36d gebildet sein, um die Trocknungskapazität zu erhöhen. Nach Durchlauf der Trocknungsstrecke 42 gelangt der jeweilige Werkstückträger 14 an einen Pufferspeicher 32, in der eine weitere Trocknung beziehungsweise Nachtrocknung erfolgen kann.

Nach dem Pufferspeicher 32 erfolgt eine weitere Beförderung zu einem der Eckumsetzer 38c beziehungsweise 38d und weiter entlang der Transportbandstrecke 36e bis zum Eckumsetzer 38e.

Angrenzend an den Eckumsetzer 38e ist die Speichereinrichtung 34 angeordnet. Ausgehend von dem Eckumsetzer 38e erfolgt eine weitere Beförderung der Werkstückträger entlang einer Rücklaufstrecke, welche die Transportbandstrecken 36f und 36g aufweist. Die Transportbandstrecken 36f und 36g können entlang der Förderrichtung ineinander übergehen, wobei die nachgelagerte Transportbandstrecke 36g eine Neigung aufweisen kann. Insbesondere kann die Transportbandstrecke 36g abwärts geneigt sein und somit eine Überführung von Werkstückträgern von der in Fig. 3 dargestellten oberen Ebene der Transporteinrichtung 30 hin zu einer in Fig. 4 dargestellten unteren Ebene der Transporteinrichtung 30 ermöglichen. Es können auch beide Transportbandstrecken 36f und 36g der Rücklaufstrecke eine Höhenneigung aufweisen.

Durch die Transportbandstrecke 36g gelangen die Werkstückträger 14 zu dem in Fig. 4 gezeigten Eckumsetzer 38f. Ausgehend vom Eckumsetzer 38f können die Werkstückträger 14 entweder zur Transportbandstrecke 36h oder zur Transportbandstrecke 36i weiter befördert werden.

Die Transportbandstrecke 36h führt zur Lifteinrichtung 44a, durch die ein Anheben der Werkstückträger 14 in die obere Ebene der Transporteinrichtung 18 erfolgt. Schließlich können angehobene Werkstückträger 14 bis zum Absetzbereich 40b weiterbefördert werden, von wo aus eine Beschickung der Drucktischplatte 16 durch die Positioniereinrichtung 20 erfolgen kann.

Die Transportbandstrecke 36i führt zunächst zum Eckumsetzer 38g und von dort weiter entlang der Transportbandstrecke 36j zur Lifteinrichtung 44b, durch die ein Anheben der Werkstückträger 14 in die obere Ebene der Transporteinrichtung 18 erfolgt. Schließlich können angehobene Werkstückträger 14 bis zum Absetzbereich 40a weiterbefördert werden, von wo aus eine Beschickung der Drucktischplatte 16 durch die Positioniereinrichtung 20 erfolgen kann.

Anstelle des Eckumsetzers 38f kann auch der Eckumsetzer 38a mit einer Hubfunktion zur direkten Beförderung der Werkstückträger 14 zwischen den beiden Ebenen der Transporteinrichtung 18 ausgestattet sein. Dies kann insbesondere dann von Vorteil sein, wenn die Druckeinrichtung 12 auf möglichst kurzem Weg überbrückt werden soll, um beispielsweise eine mehrmalige Trocknung ohne zwischenzeitliches Bedrucken des Werkstückträgers vorzunehmen. Dies kann jedoch auch ohne eine Hubfunktion des Eckumsetzers 18a bewerkstelligt werden, wie sich aus der Anordnung der Transportbandstrecken 36 ergibt.

Die voranstehend beschriebene Vorrichtung 10 eignet sich insbesondere zur Massenproduktion von dreidimensionalen Siebdruckwerkstücken. Insbesondere ermöglicht die Vorrichtung 10 eine weitgehende beziehungsweise vollständige Automatisierung des Siebdruckprozesses. Die Gefahr von Fehlbedienungen wird reduziert und das Maß an Produktivität kann mittels einer Vorrichtung 10, wie voranstehend beschrieben, signifikant erhöht werden.

## Patentansprüche

1. 3D-Siebdruckanlage (10) zur Herstellung von dreidimensionalen Siebdruckwerkstücken mit wenigstens einer Druckeinrichtung (12) für die schichtweise Erzeugung zumindest eines Siebdruckwerkstücks in mehreren Druckvorgängen und mit wenigstens einer Trocknungseinrichtung (30) für ein Siebdruckwerkstück, **dadurch gekennzeichnet, dass** die Trocknungseinrichtung (30) als Trocknungsstrecke (42) für den kontinuierlichen Trocknungsdurchlauf von Siebdruckwerkstücken ausgebildet ist.

2. 3D-Siebdruckanlage (10) nach Anspruch 1, **dadurch gekennzeichnet, dass** wenigstens ein Werkstückträger (14) für zumindest ein Siebdruckwerkstück vorgesehen ist, wobei die Druckeinrichtung (12) wenigstens eine von dem Werkstückträger (14) gesondert ausgebildete Drucktischplatte (16) aufweist, auf die der Werkstückträger (14) zur Durchführung eines Druckvorgangs positionierbar ist, und wobei der Werkstückträger (14) zwischen zwei aufeinanderfolgenden Druckvorgängen für ein Siebdruckwerkstück zur Trocknung des Siebdruckwerkstücks von der Drucktischplatte (16) lösbar ist.

3. 3D-Siebdruckanlage (10) nach Anspruch 2, **dadurch gekennzeichnet, dass** eine Transporteinrichtung (18) für den automatisierten Transport wenigstens eines Werkstückträgers (14) vorgesehen ist, wobei die Transporteinrichtung (18) einen Transportkreislauf für den automatisierten Transport des wenigstens einen Werkstückträgers (14) aufweist.

4. 3D-Siebdruckanlage (10) nach Anspruch 3, **dadurch gekennzeichnet, dass** die Transporteinrichtung (18) und/oder der Transportkreislauf zumindest abschnittsweise mehrspurig und/oder zumindest abschnittsweise einspurig ausgebildet ist.

5. 3D-Siebdruckanlage (10) nach einem der Ansprüche 2 bis 4, **dadurch gekennzeichnet, dass** eine Positionier- und/oder Handhabungseinrichtung (20) zur Vorpositionierung eines Werkstückträgers (14) auf der Drucktischplatte (16) vorgesehen ist.

6. 3D-Siebdruckanlage (10) nach Anspruch einem der Ansprüche 3 bis 5, **dadurch gekennzeichnet, dass** die Transporteinrichtung (18) zumindest abschnittsweise entlang von wenigstens zwei Ebenen verläuft und/oder dass zwischen zwei Ebenen der Transporteinrichtung (18) eine Hubeinrichtung (44) vorgesehen ist und/oder dass die Transporteinrichtung (18) zumindest abschnittsweise mit einem Höhengefälle ausgebildet ist.

7. 3D-Siebdruckanlage (10) nach zumindest einem der Ansprüche 2 bis 6, **dadurch gekennzeichnet, dass** die Trocknungsstrecke (42) für den kontinuierlichen Trocknungsdurchlauf von Werkstückträgern (14) ausgebildet ist.

8. 3D-Siebdruckanlage (10) nach einem der Ansprüche 2 bis 7, **dadurch gekennzeichnet, dass** der Werkstückträger (14) unabhängig von der Drucktischplatte (16) durch die Trocknungseinrichtung (30) verfahrbar ist.

9. 3D-Siebdruckanlage (10) nach einem der vorstehenden Ansprüche, **dadurch gekennzeichnet, dass** die Trocknungseinrichtung (30) zur Trocknung für zumindest ein Siebdruckwerkstück mittels Konvektion und/oder Wärmestrahlung eingerichtet ist und/oder dass die aktive Länge der Trocknungseinrichtung (30) variabel einstellbar ist.

10. 3D-Siebdruckanlage (10) nach einem der vorstehenden Ansprüche, **dadurch gekennzeichnet, dass** die Anzahl an Trocknungseinrichtungen (30) gleich oder geringer ist als die Anzahl an Druckeinrichtungen (12) oder dass die Anzahl an Trocknungseinrichtungen (30) größer ist als die Anzahl an Druckeinrichtungen (12) und/oder dass mehrere Druckeinrichtungen (12) vorgesehen sind, wobei jeder Druckeinrichtung (12) zumindest eine Trocknungseinrichtung (30) und/oder jeder Trocknungseinrichtung (30) zumindest einer Druckeinrichtung (12) zugeordnet ist.

11. 3D-Siebdruckanlage (10) nach zumindest einem der Ansprüche 3 bis 10, **ehe-dadurch gekennzeichnet, dass** eine Mehrzahl von Werkstückträgern (14) vorgesehen ist, die zur Durchführung eines Druckvorgangs innerhalb der Druckeinrichtung (12) positionierbar und/oder durch die Transporteinrichtung (18) automatisiert transportierbar sind.

12. 3D-Siebdruckanlage (10) nach einem der Ansprüche 3 bis 11, **dadurch gekennzeichnet, dass** die Transporteinrichtung (18) mehrspurig durch die Trocknungseinrichtung (30) führt und/oder dass im Transportkreislauf die Rückführung von der Trocknungseinrichtung (30) zur Druckeinrichtung (12) einspurig ausgestaltet ist oder weniger Spuren aufweist als der durch die Trocknungseinrichtung (30) führende Transportabschnitt.

13. 3D-Siebdruckanlage (10) nach einem der Ansprüche 3 bis 12, **dadurch gekennzeichnet, dass** die Transporteinrichtung (18) zum mehrmaligen Durchlaufen der Trocknungseinrichtung (30) durch einen Werkstückträger (14) ohne Durchlaufen der Druckeinrichtung (12) ausgebildet ist.

14. 3D-Siebdruckanlage (10) nach zumindest einem der vorstehenden Ansprüche, **dadurch gekennzeichnet, dass** mehrere modular zu einem Vorrichtungssystem verbindbare Einrichtungen vorgesehen sind und/oder dass mehrere Druckeinrichtungen (12) und/oder mehrere Trocknungseinrichtungen (30) und/oder mehrere Speichereinrichtungen (34) vorgesehen sind, die zur modularen Anordnung ausgestaltet sind.

15. Verfahren zur Herstellung von dreidimensionalen Siebdruckwerkstücken, insbesondere mit einer 3D-Siebdruckanlage (10) nach einem der vorstehenden Ansprüche, bei dem in einer Druckeinrichtung (12) ein Siebdruckwerkstück in mehreren Druckvorgängen schichtweise erzeugt wird, **dadurch gekennzeichnet, dass** das Siebdruckwerkstück zwischen zwei aufeinanderfolgenden Druckvorgängen zur Trocknung durch eine Trocknungseinrichtung (30) für den kontinuierlichen Trocknungsdurchlauf geführt wird.

## Claims

1. 3D screen printing system (10) for the production of three-dimensional screen printed workpieces, having at least one printing device (12) for the layer-by-layer production of at least one screen printed workpiece in a plurality of printing processes and having at least one drying device (30) for a screen printing workpiece, **characterized in that** the drying device (30) is designed as a drying section (42) for the continuous drying passage of screen printed workpieces.

2. 3D screen printing system (10) according to claim 1, **characterized in that** at least one workpiece carrier (14) is provided for at least one screen printing workpiece, wherein the printing device (12) has at least one printing table plate (16) which is formed separately from the workpiece carrier (14) and on which the workpiece carrier (14) can be positioned for carrying out a printing process, and wherein the workpiece carrier (14) can be detached from the printing table plate (16) between two successive printing processes for a screen printed workpiece for drying the screen printing workpiece.

3. 3D screen printing system (10) according to claim 2, **characterized in that** a transport device (18) is provided for the automated transport of at least one workpiece carrier (14), the transport device (18) having a transport circuit for the automated transport of the at least one workpiece carrier (14).

4. 3D screen printing system (10) according to claim 3, **characterized in that** the transport device (18) and/or the transport circuit is designed to be multitrack and/or single-track at least in sections.

5. 3D screen printing system (10) according to one of claims 2 to 4, **characterized in that** a positioning and/or handling device (20) is provided for pre-positioning a workpiece carrier (14) on the printing table plate (16).

6. 3D screen printing system (10) according to claim one of claims 3 to 5, **characterized in that** the transport device (18) runs at least in sections along at least two planes and/or **in that** a lifting device (44) is provided between two planes of the transport device (18) and/or **in that** the transport device (18) is designed at least in sections with a height gradient.

7. 3D screen printing system (10) according to at least one of claims 2 to 6, **characterized in that** the drying section (42) is designed for the continuous drying passage of workpiece carriers (14).

8. 3D screen printing system (10) according to one of claims 2 to 7, **characterized in that** the workpiece carrier (14) can be moved through the drying device (30) independently of the printing table plate (16).

9. 3D screen printing system (10) according to one of the preceding claims, **characterized in that** the drying device (30) is configured for drying at least one screen printed workpiece by means of convection and/or heat radiation and/or **in that** the active length of the drying device (30) is variably adjustable.

10. 3D screen printing system (10) according to one of the preceding claims, **characterized in that** the number of drying devices (30) is equal to or less than the number of printing devices (12) or **in that** the number of drying devices (30) is greater than the number of printing devices (12) and/or **in that** a plurality of printing devices (12) are provided, wherein each printing device (12) being assigned at least one drying device (30) and/or each drying device (30) being assigned at least one printing device (12).

11. 3D screen printing system (10) according to at least one of claims 3 to 10 , **characterized in that** a plurality of workpiece carriers (14) is provided, which, in order to carry out a printing process, can be positioned within the printing device (12) and/or can be transported automatically by the transport device (18).

12. 3D screen printing system (10) according to one of claims 3 to 11, **characterized in that** the transport device (18) leads through the drying device (30) in several lanes and/or **in that** in the transport circuit the return from the drying device (30) to the printing device (12) is designed with one lane or has fewer lanes than the transport section leading through the drying device (30).

13. 3D screen printing system (10) according to one of claims 3 to 12, **characterized in that** the transport device (18) is designed to pass through the drying device (30) several times by a workpiece carrier (14) without passing through the printing device (12).

14. 3D screen printing system (10) according to at least one of the preceding claims, **characterized in that** a plurality of devices which can be connected in modular fashion to form a device system are provided and/or **in that** a plurality of printing devices (12) and/or a plurality of drying devices (30) and/or a plurality of storage devices (34) are provided, which are designed for modular arrangement.

15. Method for producing three-dimensional screen printed workpieces, in particular with a 3D screen printing system (10) according to one of the preceding claims, in which a screen printed workpiece is produced layer-by-layer in a printing device (12) in a plurality of printing processes, **characterized in that** the screen printed workpiece is, for drying, passed through a drying device (30) for the continuous drying passage between two successive printing processes.

## Revendications

1. Installation de sérigraphie 3D (10) pour la fabrication de pièces imprimées par sérigraphie tridimensionnelles comportant au moins un appareil d'impression (12) pour la production couche par couche d'au moins une pièce imprimée par sérigraphie dans plusieurs processus d'impression et comportant au moins un appareil de séchage (30) pour une pièce imprimée par sérigraphie, **caractérisée en ce que** l'appareil de séchage (30) est réalisé en tant que tronçon de séchage (42) pour le passage de séchage continu de pièces imprimées par sérigraphie.

2. Installation de sérigraphie 3D (10) selon la revendication 1, **caractérisée en ce qu'**au moins un support de pièce (14) est prévu pour au moins une pièce imprimée par sérigraphie, dans laquelle l'appareil d'impression (12) présente au moins un plateau de table d'impression (16) réalisé séparément du support de pièce (14) et sur lequel le support de pièce (14) peut être positionné pour la réalisation d'un processus d'impression, et dans laquelle le support de pièce (14) peut être détaché du plateau de table d'impression (16) entre deux processus d'impression successifs pour une pièce imprimée par sérigraphie afin de sécher la pièce imprimée par sérigraphie.

3. Installation de sérigraphie 3D (10) selon la revendication 2, **caractérisée en ce qu'**un appareil de transport (18) est prévu pour le transport automatisé d'au moins un support de pièce (14), dans laquelle l'appareil de transport (18) présente un circuit de transport pour le transport automatisé de l'au moins un support de pièce (14).

4. Installation de sérigraphie 3D (10) selon la revendication 3, **caractérisée en ce que** l'appareil de transport (18) et/ou le circuit de transport sont réalisés en plusieurs voies au moins dans certaines sections et/ou en une voie au moins dans certaines sections.

5. Installation de sérigraphie 3D (10) selon l'une des revendications 2 à 4, **caractérisée en ce qu'**un appareil de positionnement et/ou de manipulation (20) permettant le prépositionnement d'un support de pièce (14) sur le plateau de table d'impression (16) est prévu.

6. Installation de sérigraphie 3D (10) selon la revendication l'une des revendications 3 à 5, **caractérisée en ce que** l'appareil de transport (18) s'étend le long d'au moins deux plans au moins dans certaines sections **et/ou en ce qu'**un appareil de levage (44) est prévu entre deux plans de l'appareil de transport (18) **et/ou en ce que** l'appareil de transport (18) est réalisé avec une hauteur en pente au moins dans certaines sections.

7. Installation de sérigraphie 3D (10) selon au moins l'une des revendications 2 à 6, **caractérisée en ce que** le tronçon de séchage (42) est réalisé pour le passage de séchage continu de supports de pièce (14).

8. Installation de sérigraphie 3D (10) selon l'une des revendications 2 à 7, **caractérisée en ce que** le support de pièce (14) peut être déplacé par l'appareil de séchage (30) indépendamment du plateau de table d'impression (16).

9. Installation de sérigraphie 3D (10) selon l'une des revendications précédentes, **caractérisée en ce que** l'appareil de séchage (30) est conçu pour le séchage par convection et/ou rayonnement thermique pour au moins une pièce imprimée par sérigraphie **et/ou en ce que** la longueur active de l'appareil de séchage (30) est réglable de manière variable.

10. Installation de sérigraphie 3D (10) selon l'une des revendications précédentes, **caractérisée en ce que** le nombre d'appareils de séchage (30) est égal ou inférieur au nombre d'appareils d'impression (12) **ou en ce que** le nombre d'appareils de séchage (30) est supérieur au nombre d'appareils d'impression (12) **et/ou en ce que** plusieurs appareils d'impression (12) sont prévus, dans laquelle au moins un appareil de séchage (30) est associé à chaque appareil d'impression (12) et/ou au moins un appareil d'impression (12) est associé à chaque appareil de séchage (30).

11. Installation de sérigraphie 3D (10) selon au moins l'une des revendications 3 à 10, **caractérisée en ce qu'**une pluralité de supports de pièce (14) sont prévus, lesquels peuvent être positionnés à l'intérieur de l'appareil d'impression (12) pour la réalisation d'un processus d'impression et/ou peuvent être transportés de manière automatisée par l'appareil de transport (18).

12. Installation de sérigraphie 3D (10) selon l'une des revendications 3 à 11, **caractérisée en ce que** l'appareil de transport (18) passe en plusieurs voies à travers l'appareil de séchage (30) **et/ou en ce que,** dans le circuit de transport, le retour depuis l'appareil de séchage (30) jusqu'à l'appareil d'impression (12) est conçu en une voie ou présente moins de voies que la section de transport passant à travers l'appareil de séchage (30).

13. Installation de sérigraphie 3D (10) selon l'une des revendications 3 à 12, **caractérisée en ce que** l'appareil de transport (18) est réalisé pour la traversée à plusieurs reprises de l'appareil de séchage (30) par un support de pièce (14) sans passer par l'appareil d'impression (12).

14. Installation de sérigraphie 3D (10) selon au moins l'une des revendications précédentes, **caractérisée en ce que** plusieurs appareils pouvant être reliés de manière modulaire pour former un système de dispositifs sont prévus **et/ou en ce que** plusieurs appareils d'impression (12) et/ou plusieurs appareils de séchage (30) et/ou plusieurs appareils de stockage (34) sont prévus, lesquels sont conçus pour former un agencement modulaire.

15. Procédé de fabrication de pièces imprimées par sérigraphie tridimensionnelles, en particulier à l'aide d'une installation de sérigraphie 3D (10) selon l'une des revendications précédentes, dans lequel une pièce imprimée par sérigraphie est produite couche par couche dans un appareil d'impression (12) dans plusieurs processus d'impression, **caractérisé en ce que,** pour le séchage, la pièce imprimée par sérigraphie est guidée à travers un appareil de séchage (30) pour le passage de séchage continu entre deux processus d'impression successifs.
